# EUROPEAN PATENT APPLICATION

(11) **EP 4 770 305 A1**
(43) Date of publication of application: **01.07.2026**
(21) Application number: 25218900.6
(22) Date of filing: 27.11.2025
(51) Int. Cl.: H10B 12/00, H10D 62/10, H10D 30/67, H10D 30/01

(54) **SEMICONDUCTOR DEVICE AND METHOD FOR FABRICATING THE SAME**

(30) Priority: 30.12.2024 KR 20240200972
(71) Applicant: SK hynix Inc., Bubal-eub Icheon-si Gyeonggi-do 17336 (KR)
(72) Inventor: KWON, Jeong Hoon, 17336 Icheon-si, Gyeonggi-do (KR); KIM, Dong Hyoub, 17336 Icheon-si, Gyeonggi-do (KR)
(74) Representative: Isarpatent

(57) **Abstract**

A method for fabricating a semiconductor device including high-integrated memory cells and the semiconductor device is provided. The method includes forming a horizontal arrangement of nano sheet target patterns over a substrate, wherein the nano sheet target patterns include initial sheets that are horizontally oriented and sheet expansion tabs disposed on both sides of each of the initial sheets; performing a surface treatment on the nano sheet target patterns to form a horizontal arrangement of narrow sheets and nano sheet dielectric layers, each of the nano sheet dielectric layers surrounding a different one of the narrow sheets; and forming a horizontal conductive line on the nano sheet dielectric layers, the horizontal conductive line surrounding the narrow sheets.

## Description

### BACKGROUND

### 1. Field

Various embodiments of the present disclosure relate to a semiconductor device, and more particularly, to a semiconductor device including three-dimensional (3D) memory cells, and a method for fabricating the semiconductor device.

### 2. Description of the Related Art

Recently, there have been increasing demands for larger capacity and greater miniaturization of memory devices. In order to cope with these demands, three-dimensional (3D) memory devices that include stacked memory cells have been proposed.

### SUMMARY

Embodiments of the present disclosure are directed to a semiconductor device including high-integrated memory cells, and a method for fabricating the semiconductor device.

In accordance with an embodiment of the present disclosure, a method for fabricating a semiconductor device may include: forming a horizontal arrangement of nano sheet target patterns over a substrate, wherein the nano sheet target patterns include initial sheets that are horizontally oriented and sheet expansion tabs disposed on both sides of each of the initial sheets; performing a surface treatment on the nano sheet target patterns to form a horizontal arrangement of narrow sheets and nano sheet dielectric layers, each of the nano sheet dielectric layers surrounding a different one of the narrow sheets; and forming a horizontal conductive line on the nano sheet dielectric layers, the horizontal conductive line surrounding the narrow sheets.

In some embodiments, the method further comprising performing an annealing process after the forming of the liners.

In accordance with an embodiment of the present disclosure, a method for fabricating a semiconductor device may include: forming, over a substrate, a mold stack including a vertical arrangement of mold layers; forming sacrificial isolation openings in the mold stack; forming liners on surfaces of the sacrificial isolation openings; forming a first linear opening in the mold stack; trimming first portions of the mold layers through the first linear opening to form a horizontal arrangement of initial sheets; cutting the liners through the first linear opening to form sheet expansion tabs disposed on both sides of each of the initial sheets; performing a surface treatment on the initial sheets and the sheet expansion tabs to form a horizontal arrangement of narrow sheets and nano sheet dielectric layers surrounding the narrow sheets; and forming, on the nano sheet dielectric layers, a horizontal conductive line surrounding the narrow sheets.

Wherein the liners each include epi-like polysilicon.

In some embodiments, the method further comprising performing an annealing process after the forming of the liners.

wherein the performing the surface treatment on the initial sheets and the sheet expansion tabs includes: forming a deposition portion surrounding the initial sheets and the sheet expansion tabs; and forming an oxidation portion by oxidizing surfaces of the initial sheets and the sheet expansion tabs.

Wherein the deposition portion and the oxidation portion each include silicon oxide.

Wherein the deposition portion includes metal-based oxide, and the oxidation portion includes silicon oxide.

Wherein the mold stack further includes a vertical arrangement of sacrificial mold layers, and the mold layers are alternately stacked with the sacrificial mold layers to form the mold stack.

Wherein the mold layers each include monocrystalline silicon, and the sacrificial mold layers each include silicon germanium.

In some embodiments, the method further comprising: after the forming of the horizontal conductive line, forming first contact nodes coupled to the narrow sheets; forming vertical conductive lines on the first contact nodes;
forming a second linear opening in the mold stack; horizontally recessing second portions of the mold layers through the second linear opening to form wide sheets; forming second contact nodes on the wide sheets; and forming data storage elements on the second contact nodes.

Wherein the first and second contact nodes each include a doped silicon layer.

In accordance with an embodiment of the present disclosure, a semiconductor device may include: a horizontal arrangement of nano sheets including first doped regions, second doped regions, and channels between the first doped regions and the second doped regions; nano sheet dielectric layers including oxidation portions and deposition portions, each of the oxidation portions surrounding a different one of the channels of the nano sheets, each of the deposition portions surrounding a different one of the oxidation portions; horizontal conductive lines horizontally oriented on the nano sheet dielectric layers while surrounding the channels of the nano sheets; vertical conductive lines each coupled to a different one of the first doped regions of the nano sheets; and data storage elements each coupled to a different one of the second doped regions of the nano sheets.

### BRIEF DESCRIPTION OF THE DRAWINGS

FIG. 1A is a schematic perspective view illustrating a memory cell in accordance with an embodiment of the present disclosure.
FIG. 1B is a schematic cross-sectional view of the memory cell illustrated in FIG. 1A.
FIG. 2A is a schematic perspective view illustrating a semiconductor device in accordance with an embodiment of the present disclosure.
FIG. 2B is a partial perspective view illustrating a first spacer.
FIG. 2C is a partial perspective view illustrating a second spacer.
FIG. 3 is a schematic perspective view illustrating a semiconductor device in accordance with an embodiment of the present disclosure.
FIG. 4A is a schematic plan view illustrating a semiconductor device in accordance with an embodiment of the present disclosure.
FIG. 4B is a schematic cross-sectional view of the semiconductor device taken along line A-A' illustrated in FIG. 4A.
FIG. 4C is a schematic cross-sectional view of the semiconductor device taken along line B-B' illustrated in FIG. 4A.
FIGS. 5A to 25B illustrate various views of a semiconductor device formed utilizing a method for fabricating the semiconductor device in accordance with an embodiment of the present disclosure.
FIG. 26 is a schematic cross-sectional view of a semiconductor device in accordance with an embodiment of the present disclosure.
FIGS. 27A and 27B are schematic cross-sectional views of a semiconductor device in accordance with embodiments of the present disclosure.
FIGS. 28A and 28B illustrate various views illustrating a stack assembly in accordance with embodiments of the present disclosure.

### DETAILED DESCRIPTION

Various embodiments of the present disclosure described herein may be described with reference to cross-sectional views, plan views and block diagrams, which are ideal schematic views of a semiconductor device. It is noted that the structures of the drawings may be modified by fabricating techniques and/or tolerances. The embodiments of the present disclosure are not limited to the described embodiments and the specific structures illustrated in the drawings, but may include other embodiments, or modifications of the described embodiments including any changes in the structures that may be produced according to requirements of the fabricating process. Accordingly, the regions illustrated in the drawings have schematic attributes, and the shapes of the regions illustrated in the drawings are intended to illustrate specific structures of regions of the elements, and are not intended to limit the scope of the disclosure.

The following embodiments provide three-dimensional memory cells, in which memory cells are vertically stacked to increase memory cell density and reduce parasitic capacitance.

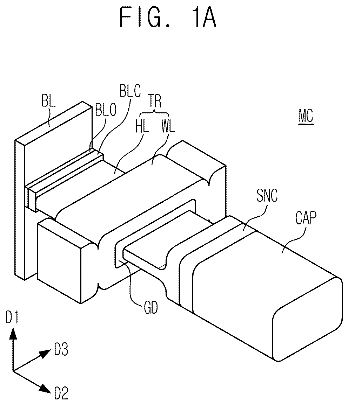

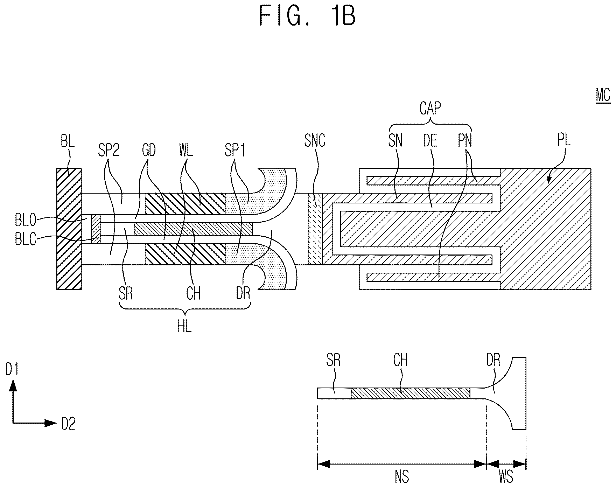

FIG. 1A is a schematic perspective view illustrating a memory cell MC in accordance with an embodiment of the present disclosure. FIG. 1B is a schematic cross-sectional view of the memory cell MC illustrated in FIG. 1A.

Referring to FIGS. 1A and 1B, the memory cell MC may include a first conductive line BL, a switching element TR, and a data storage element CAP.

The first conductive line BL may be vertically oriented in a first direction D1. The first conductive line BL may include a bit line. The first conductive line BL may be referred to as a "vertical conductive line", a "vertically-oriented bit line", a "vertically-extending bit line", or a "pillar-shaped bit line". The first conductive line BL may include a conductive material. The first conductive line BL may include a silicon-based material, a metal-based material, or a combination thereof. The first conductive line BL may include polysilicon, metal, metal nitride, metal silicide, or a combination thereof. The first conductive line BL may include polysilicon, titanium nitride, tungsten, or a combination thereof. For example, the first conductive line BL may include a titanium nitride/tungsten (TiN/W) stack in which titanium nitride (TiN) and tungsten (W) are sequentially stacked.

The switching element TR has a function of controlling voltage or current supply to the data storage element CAP during a data write operation and a data read operation performed on the data storage element CAP. The switching element TR may include a nano sheet HL, a nano sheet dielectric layer GD, and a second conductive line WL. The second conductive line WL may include a horizontal conductive line or a horizontal word line, and the nano sheet HL may include an active layer. The switching element TR may include a transistor, and in this case, the second conductive line WL may serve as a gate or a gate electrode. The switching element TR may also be referred to as a "nano sheet transistor", an "access element" or a "selection element". The second conductive line WL may be referred to as a "horizontal gate electrode" or a "horizontal word line".

The nano sheet HL may extend in a second direction D2 that intersects with the first direction D1. The second conductive line WL may horizontally extend in a third direction D3 that intersects with the first direction D1 and the second direction D2. The first direction D1 may be a vertical direction, the second direction D2 may be a first horizontal direction, and the third direction D3 may be a second horizontal direction (for example, perpendicular to the second direction D2). The nano sheet HL may extend in the first horizontal direction, i.e., the second direction D2, and the second conductive line WL may extend in the second horizontal direction, i.e., the third direction D3. The nano sheet HL may be referred to as a "horizontal layer" or a "channel body".

The nano sheet HL may include a channel CH, a first doped region SR between the channel CH and the first conductive line BL, and a second doped region DR between the channel CH and the data storage element CAP. The first doped region SR may be electrically coupled to the first conductive line BL, and the second doped region DR may be electrically coupled to the data storage element CAP. A height of the second doped region DR in the first direction D1 may be greater than a height of the channel CH in the first direction D1. A length of the second doped region DR in the second direction D2 may be less than a length of the channel CH in the second direction D2. The lengths of the first doped region SR, the channel CH and the second doped region DR in the third direction D3 may be equal to one another.

The nano sheet HL may include a first sheet region NS and a second sheet region WS that are horizontally disposed in the second direction D2. The second sheet region WS may extend from the first sheet region NS. The second sheet region WS may have a thickness that gradually increases in the second direction D2 from the first sheet region NS toward the data storage element CAP between the first sheet region NS and the data storage element CAP. An average vertical height or thickness of the second sheet region WS in the first direction D1 may be greater than an average vertical height or thickness of the first sheet region NS. Hereinafter, the first sheet region NS is referred to as a "narrow sheet", and the second sheet region WS is referred to as a "wide sheet".

The narrow sheet NS may have a flat plate shape. The wide sheet WS may have a fan-like shape. The wide sheet WS may have a thickness that gradually increases in the second direction D2. The narrow sheet NS may be referred to as a "flat plate-shaped sheet", and the wide sheet WS may be referred to as a "fan-like shaped sheet". Upper and lower surfaces of the wide sheet WS may each have a curvature.

The first doped region SR and the channel CH may be disposed in the narrow sheet NS, and the second doped region DR may be disposed in the wide sheet WS. The channel CH formed in the narrow sheet NS may be referred to as a "narrow channel" or a "flat channel". A portion of the second doped region DR may extend to be disposed in the narrow sheet NS. The second doped region DR may include a thick portion disposed in the wide sheet WS and a thin portion disposed in the narrow sheet NS. One side of the wide sheet WS and one side of the second doped region DR, which contact the data storage element CAP, may each have a flat side shape.

A horizontal length of the wide sheet WS in the second direction D2 may be less than a horizontal length of the narrow sheet NS. The narrow sheet NS may be referred to as a "long sheet", and the wide sheet WS may be referred to as a "short sheet".

The nano sheet HL may include a semiconductive material. For example, the nano sheet HL may include polysilicon, monocrystalline silicon, germanium, or silicon-germanium. In some embodiments, the nano sheet HL may include an oxide semiconductor material. For example, the oxide semiconductor material may include indium gallium zinc oxide (IGZO), InSnZnO, ZnSnO, or a combination thereof. In some embodiments, the nano sheet HL may include conductive metal oxide.

In some embodiments, the nano sheet HL may include a two-dimensional material or a two-dimensional semiconductor material. The two-dimensional semiconductor material may refer to a semiconductor material having a layered structure in which constituent atoms are two-dimensionally bonded. The two-dimensional semiconductor material has excellent electrical properties, and even when a thickness of the two-dimensional semiconductor material is reduced to a nano scale, the two-dimensional semiconductor material may maintain high mobility without significantly changing its property. For example, the nano sheet HL may include molybdenum disulfide (MoS₂), tungsten disulfide (WS₂₎, or molybdenum diselenide (MoSe₂).

When the nano sheet HL is formed of the oxide semiconductor material, the channel CH may also be formed of the oxide semiconductor material, and the first and second doped regions SR and DR may be omitted. The nano sheet HL may also be referred to as an "active layer" or a "thin body".

The first doped region SR and the second doped region DR may be doped with an impurity having the same conductivity type. Each of the first doped region SR and the second doped region DR may be doped with an N-type conductive impurity or a P-type conductive impurity. For example, the conductive impurity may include arsenic (As), phosphorus (P), boron (B), indium (In), and combinations thereof. The first doped region SR may be electrically coupled to the first conductive line BL, and the second doped region DR may be electrically coupled to the data storage element CAP. The first and second doped regions SR and DR may be referred to as "first and second source/drain regions".

The nano sheet HL may be horizontally oriented in the second direction D2 from the first conductive line BL.

The second conductive line WL may have a gate-all-around (GAA) structure. For example, the second conductive line WL may surround the nano sheet HL and extend in the third direction D3. The nano sheet dielectric layer GD may be formed between the nano sheet HL and the second conductive line WL. The nano sheet dielectric layer GD may surround the nano sheet HL. The second conductive line WL may surround the nano sheet HL on the nano sheet dielectric layer GD.

The second conductive line WL may include a metal material, a metal-based material, a semiconductive material, or a combination thereof. The second conductive line WL may include molybdenum, molybdenum nitride, ruthenium, titanium nitride, tungsten, polysilicon, or a combination thereof. For example, the second conductive line WL may include a titanium nitride and tungsten (TiN/W) stack in which titanium nitride and tungsten are sequentially stacked. The second conductive line WL may include an N-type work function material or a P-type work function material. The N-type work function material may have a low work function of approximately 4.5 eV or less, and the P-type work function material may have a high work function of approximately 4.5 eV or greater. The second conductive line WL may include a stack of a low work function material and a high work function material.

The nano sheet dielectric layer GD may be disposed between the nano sheet HL and the second conductive line WL. The nano sheet dielectric layer GD may be referred to as a "gate dielectric layer" or a "channel-side dielectric layer". The nano sheet dielectric layer GD may include silicon oxide, silicon nitride, metal oxide, metal oxynitride, metal silicate, a high-k material, a ferroelectric material, an anti-ferroelectric material, or a combination thereof. The nano sheet dielectric layer GD may include silicon oxide (SiO₂), silicon nitride (Si₃N₄₎, hafnium oxide (HfO₂), aluminum oxide (Al₂O₃), zirconium oxide (ZrO₂), aluminum oxynitride (AlON), hafnium oxynitride (HfON), hafnium silicate (HfSiO), hafnium silicon oxynitride (HfSiON), hafnium zirconium oxide (HfZrO), or a combination thereof. The nano sheet dielectric layer GD may be formed by thermal oxidation of a semiconductive material. The nano sheet dielectric layer GD may be formed by a combination of deposition of a nano sheet dielectric material and oxidation of a semiconductive material.

The data storage element CAP may include a memory element such as a capacitor. The data storage element CAP may be horizontally disposed in the second direction D2 from the switching element TR. The data storage element CAP may include a first electrode SN, a second electrode PN, and a dielectric layer DE between the first electrode SN and the second electrode PN. The first electrode SN may be a storage node, and the second electrode PN may be a plate node. The first electrode SN may horizontally extend in the second direction D2 from the nano sheet HL. The first electrode SN, the dielectric layer DE and the second electrode PN may be horizontally disposed in the second direction D2. The first electrode SN may include an inner space and a plurality of outer surfaces. The inner space of the first electrode SN may include a plurality of inner surfaces. The outer surfaces of the first electrode SN may include a vertical outer surface and a plurality of horizontal outer surfaces. The vertical outer surface of the first electrode SN may vertically extend in the first direction D1. The horizontal outer surfaces of the first electrode SN may horizontally extend in the second direction D2 or the third direction D3. The inner space of the first electrode SN may be a three-dimensional space. The dielectric layer DE may conformally cover the inner surfaces of the first electrode SN. The second electrode PN may be disposed in the inner space of the first electrode SN on the dielectric layer DE. Some of the outer surfaces of the first electrode SN may be electrically coupled to the second doped region DR of the nano sheet HL. The second electrode PN of the data storage element CAP may be coupled to a common plate PL.

The data storage element CAP may have a three-dimensional structure. The first electrode SN may have a three-dimensional structure, for example, a horizontal three-dimensional structure that is oriented in the second direction D2. In an example of the three-dimensional structure, the first electrode SN may have a cylindrical shape. The cylindrical shape of the first electrode SN may include cylindrical inner surfaces and cylindrical outer surfaces. Some of the cylindrical outer surfaces of the first electrode SN may be electrically coupled to the second doped region DR of the nano sheet HL. The dielectric layer DE and the second electrode PN may be disposed on the cylindrical inner surfaces and cylindrical outer surfaces of the first electrode SN.

In some embodiments, the first electrode SN may have a pillar shape or a pylinder shape. The pylinder shape may refer to a structure in which a pillar shape and a cylindrical shape are merged.

Each of the first electrode SN and the second electrode PN may include metal, noble metal, metal nitride, conductive metal oxide, conductive noble metal oxide, metal carbide, metal silicide, or a combination thereof. For example, each of the first electrode SN and the second electrode PN may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum nitride (MoN), molybdenum oxide (MoO), a titanium nitride/tungsten (TiN/W) stack, a tungsten nitride/tungsten (WN/W) stack, a titanium silicon nitride/titanium nitride (TiSiN/TiN) stack, a titanium nitride/titanium silicon nitride (TiN/TiSiN) stack, a titanium silicon nitride/titanium nitride/tungsten (TiSiN/TiN/W) stack, or a combination thereof. The second electrode PN may also include a combination of a metal-based material and a silicon-based material. For example, the second electrode PN may be a titanium nitride/silicon germanium/tungsten nitride (TiN/SiGe/WN) stack. In the titanium nitride/silicon germanium/tungsten nitride (TiN/SiGe/WN) stack, silicon germanium may be a gap-fill material that fills the inside of the first electrode SN, titanium nitride (TiN) may serve as the second electrode PN of the data storage element CAP, and tungsten nitride may be a low-resistance material.

The dielectric layer DE may be referred to as a "capacitor dielectric layer" or a "memory layer". The dielectric layer DE may include silicon oxide, silicon nitride, a high-k material, a perovskite material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). In some embodiments, the dielectric layer DE may be formed of a composite layer including two or more layers of the above-described high-k material.

The dielectric layer DE may be formed of zirconium (Zr)-based oxide. The dielectric layer DE may have a stack structure containing zirconium oxide (ZrO₂). The dielectric layer DE may include a ZA (ZrO₂/Al₂O₃) stack or a ZAZ (ZrO₂/Al₂O₃/ZrO₂) stack. The ZA stack may have a structure in which aluminum oxide (Al₂O₃) is stacked on zirconium oxide (ZrO₂). The ZAZ stack may have a structure in which zirconium oxide (ZrO₂), aluminum oxide (Al₂O₃) and zirconium oxide (ZrO₂) are sequentially stacked. Each of the ZA stack and the ZAZ stack may be referred to as a "zirconium oxide (ZrO₂)-based layer".

In some embodiments, the dielectric layer DE may be formed of hafnium (Hf)-based oxide. The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked on hafnium oxide (HfO₂). The HAH stack may have a structure in which hafnium oxide (HfO₂), aluminum oxide (Al₂O₃) and hafnium oxide (HfO₂) are sequentially stacked. Each of the HA stack and the HAH stack may be referred to as a "hafnium oxide (HfO₂)-based layer". In the ZA stack, ZAZ stack, HA stack and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material having a greater band gap energy than the high-k material. The dielectric layer DE may include silicon oxide (SiO₂) as a high band gap material other than aluminum oxide (Al₂O₃). Because the dielectric layer DE includes a high band gap material, leakage current may be suppressed. The high band gap material may be thinner than the high-k material.

In some embodiments, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, an HAHA (HfO₂/Al₂O₃/HfO₂/Al₂O₃) stack, an HAHAH (HfO₂/Al₂O₃/HfO₂/Al₂O₃/HfO₂) stack, an HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, an HZHZ (HfO₂/ZrO₂/HfO₂/ZrO₂) stack, an AHZAZHA (Al₂O₃/HfO₂/ZrO₂/Al₂O₃/ZrO₂/HfO₂/Al₂O₃) stack, or a ZHZAZHZAT (ZrO₂/HfO₂/ZrO₂/Al₂O₃/ZrO₂/HfO₂/ZrO₂/Al₂O₃/TiO₂) stack. In the above-described stack structures, aluminum oxide (Al₂O₃) may be thinner than zirconium oxide (ZrO₂) and hafnium oxide (HfO₂).

In some embodiments, the dielectric layer DE may include a high-k material and a high band gap material. The dielectric layer DE may have a laminated structure in which a plurality of high-k materials and a plurality of high band gap materials are stacked or an intermixed structure in which a high-k material and a high band gap material are intermixed.

In some embodiments, the dielectric layer DE may include a ferroelectric material, an anti-ferroelectric material, or a combination thereof. For example, the dielectric layer DE may include HfZrO.

In some embodiments, the dielectric layer DE may include a combination of a high-k material and a ferroelectric material, a combination of a high-k material and an anti-ferroelectric material, or a combination of a high-k material or a ferroelectric material and an anti-ferroelectric material.

In some embodiments, the data storage element CAP may further include a plurality of interface control layers to alleviate leakage current. The interface control layers may each include titanium oxide (TiO₂), tantalum oxide (Ta₂O₅), niobium oxide (Nb₂O₅), niobium nitride (NbN), niobium oxynitride (NbON), or a combination thereof. The data storage element CAP may include a first interface control layer, a second interface control layer, or a combination thereof. The first interface control layer and the second interface control layer may be conductive or dielectric. The first interface control layer may be formed between the first electrode SN and the dielectric layer DE. The second interface control layer may be formed between the dielectric layer DE and the second electrode PN. The first interface control layer and the second interface control layer may be the same material or different materials. For example, a structure of the data storage element CAP in which the first interface control layer, the dielectric layer DE and the second interface control layer are sequentially stacked may include an NZHZAZHZATN
(Nb₂O₅/ZrO₂/HfO₂/ZrO₂/Al₂O₃/ZrO₂/HfO₂/ZrO₂/Al₂O₃/TiO₂/Nb₂O₅) stack.

The data storage element CAP may include a three-dimensional capacitor. The data storage element CAP may include a Metal-Insulator-Metal (MIM) capacitor. The data storage element CAP may be replaced with another data storage material. For example, the data storage material may be a thyristor, a phase-change material, a Magnetic Tunnel Junction (MTJ), or a variable resistance material.

The memory cell MC may further include a first contact node BLC and a second contact node SNC. The first contact node BLC may be disposed between the first conductive line BL and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and the first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped silicon, and the second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of the channel CH in the first direction D1. The first and second contact nodes BLC and SNC may each include phosphorus-doped polysilicon or arsenic-doped polysilicon.

In some embodiments, the second contact node SNC may be selectively grown from the wide sheet WS of the nano sheet HL. The second contact node SNC may be formed by selective epitaxial growth (SEG). For example, the second contact node SNC may be a silicon epitaxial layer formed by the SEG. The second contact node SNC may be a doped silicon epitaxial layer.

In some embodiments, the first contact node BLC may also be selectively grown from the narrow sheet NS of the nano sheet HL. The first contact node BLC may be formed by selective epitaxial growth (SEG). For example, the first contact node BLC may be a silicon epitaxial layer formed by the SEG. The first contact node BLC may be a doped silicon epitaxial layer.

The first contact node BLC may be a narrow sheet-side contact node, and the second contact node SNC may be a wide sheet-side contact node.

The nano sheet HL may include a first edge and a second edge. The first edge may refer to a portion of the first doped region SR electrically coupled to the first conductive line BL. The second edge may refer to a portion of the second doped region DR electrically coupled to the first electrode SN of the data storage element CAP.

The memory cell MC may further include an ohmic contact layer BLO between the first contact node BLC and the first conductive line BL. The ohmic contact layer BLO may include metal silicide such as titanium silicide or molybdenum silicide.

The memory cell MC may further include a first spacer SP1 and a second spacer SP2. The first spacer SP1 may be disposed between the second conductive line WL and the second doped region DR. The second spacer SP2 may be disposed between the first conductive line BL and the second conductive line WL. The first and second spacers SP1 and SP2 may each include a dielectric material. The first and second spacers SP1 and SP2 may each include silicon oxide, silicon nitride, or a combination thereof. The first spacer SP1 may include silicon nitride. The second spacer SP2 may be a stack of silicon nitride and silicon oxide. The first and second spacers SP1 and SP2 may be disposed on both sidewalls of the second conductive line WL. That is, the first and second spacers SP1 and SP2 may extend in the third direction D3. The first spacer SP1 may surround the second doped region DR of the nano sheet HL, and the second spacer SP2 may surround the first doped region SR of the nano sheet HL.

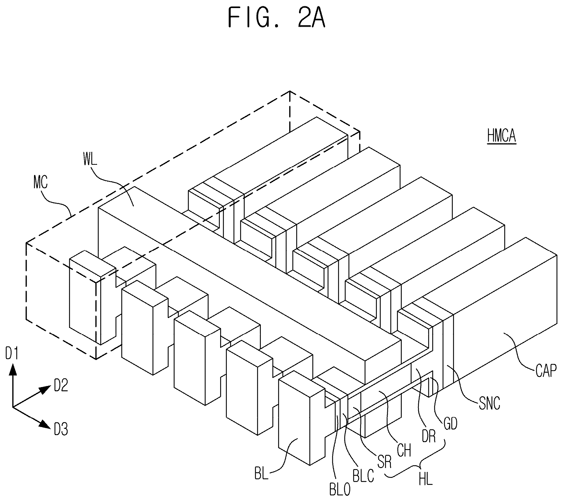

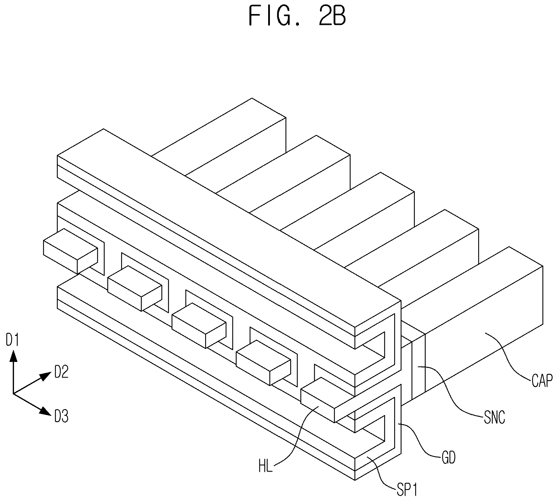

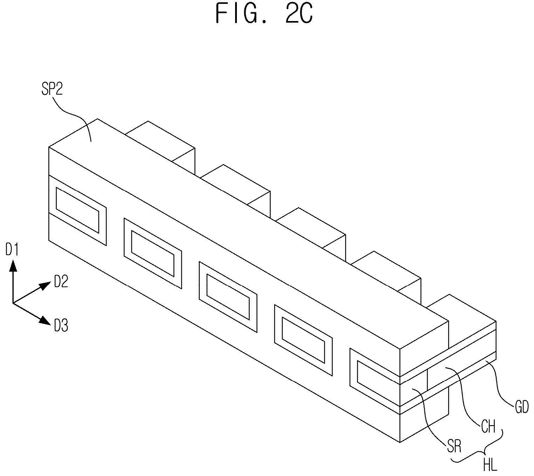

FIG. 2A is a schematic view illustrating a semiconductor device in accordance with an embodiment of the present disclosure. FIG. 2B is a partial perspective view illustrating a first spacer SP1. FIG. 2C is a partial perspective view illustrating a second spacer SP2.

FIG. 2A illustrates a horizontal memory cell array HMCA having a structure in which a plurality of memory cells MC as described above with reference to FIGS. 1A and 1B are disposed in a third direction D3.

Referring to FIGS. 1A, 1B, and 2A, the horizontal memory cell array HMCA may include a horizontal arrangement of the memory cells MC. The memory cells MC of the horizontal memory cell array HMCA may be horizontally spaced apart in a third direction D3. Each of the memory cells MC of the horizontal memory cell array HMCA may be coupled to a different one of first conductive lines BL. The memory cells MC of the horizontal memory cell array HMCA may share one second conductive line WL. Each of the memory cells MC may include a first conductive line BL, a nano sheet HL, and a data storage element CAP. The nano sheet HL may include a first doped region SR, a channel CH, and a second doped region DR. A first contact node BLC and an ohmic contact layer BLO may be formed between the first doped region SR of the nano sheet HL and the first conductive line BL. A second contact node SNC may be formed between the second doped region DR of the nano sheet HL and the data storage element CAP. The nano sheet HL may be surrounded by a nano sheet dielectric layer GD. The second conductive line WL may extend in the third direction D3 while surrounding the channels CH of the nano sheets HL on the nano sheet dielectric layer GD.

The horizontal memory cell array HMCA may further include the first spacer SP1 and the second spacer SP2 as described above with reference to FIG. 1B.

Referring to FIG. 2B, the first spacer SP1 may have an integral structure of extending in a first direction D1. The first spacer SP1 may surround portions of the nano sheets HL, that is, the second doped regions DR of the nano sheets HL disposed at the same horizontal level. Portions of the first spacer SP1 may be disposed between the nano sheets HL, and thus the first spacer SP1 may vertically extend in the first direction D1. A cross-section of the first spacer SP1 may have a cup shape.

Referring to FIG. 2C, the second spacer SP2 may extend in the third direction D3 while surrounding portions of the nano sheets HL, that is, the first doped regions SR of the nano sheets HL disposed at the same horizontal level.

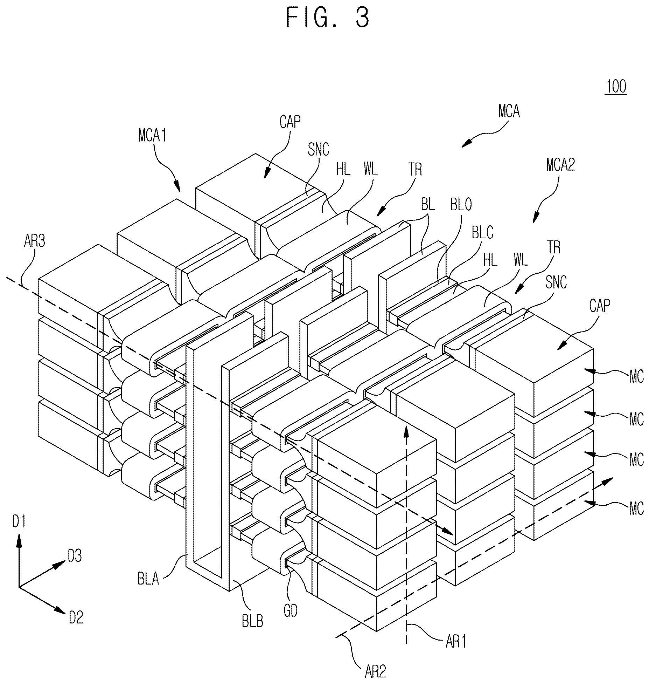

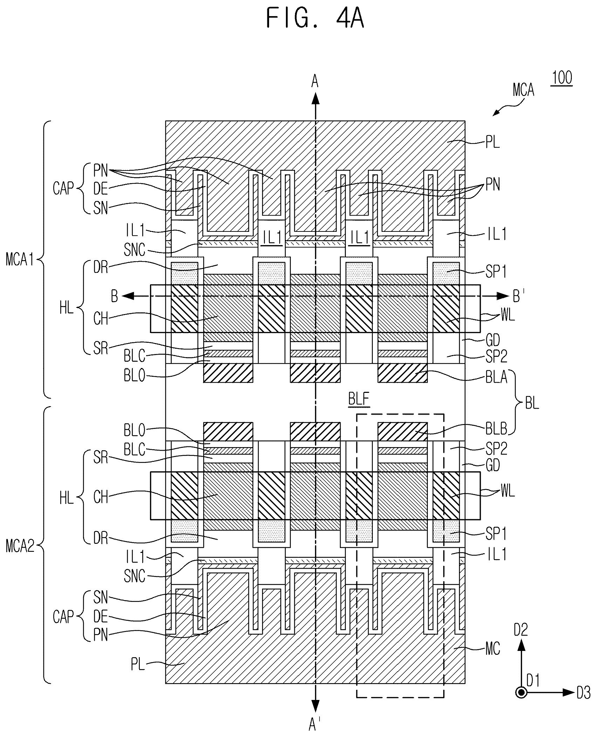

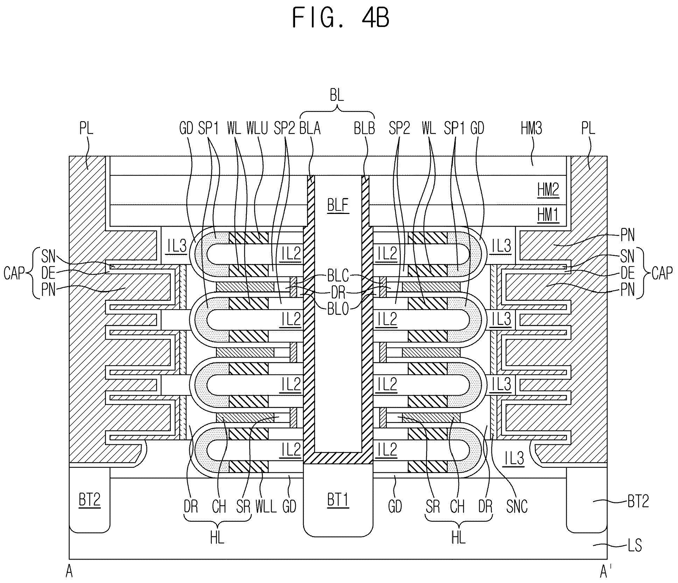

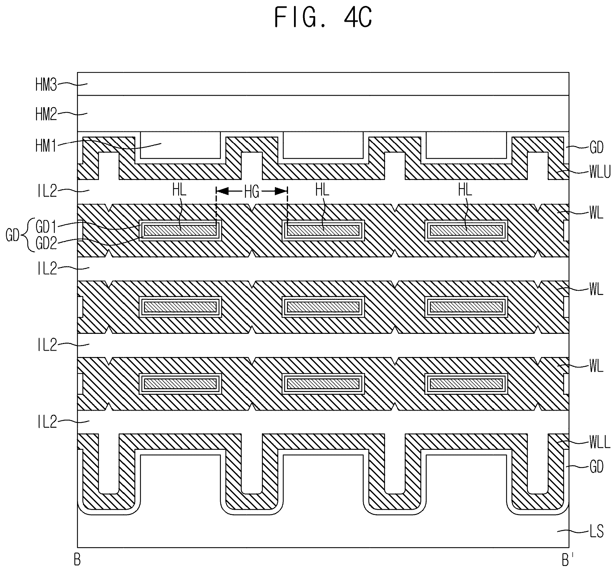

FIG. 3 is a schematic perspective view illustrating a semiconductor device 100 in accordance with an embodiment of the present disclosure. FIG. 4A is a schematic plan view illustrating the semiconductor device 100 illustrated in FIG. 3. FIG. 4B is a schematic cross-sectional view of the semiconductor device 100 taken along line A-A' illustrated in FIG. 4A. FIG. 4C is a schematic cross-sectional view of the semiconductor device 100 taken along line B-B' illustrated in FIG. 4A. Detailed descriptions of overlapping components are provided above with reference to FIGS. 1A to 2C.

Referring to FIGS. 3, 4A to 4C, the semiconductor device 100 may include a memory cell array MCA. The memory cell array MCA may include a three-dimensional array of memory cells MC. Detailed descriptions of the memory cells MC are provided above with reference to FIGS. 1A and 1B. The memory cell array MCA may be disposed on a lower structure LS.

The lower structure LS may be disposed at a lower level than the memory cell array MCA.

The lower structure LS may be a material appropriate for semiconductor processing. The lower structure LS may include a semiconductor substrate, a conductive material, a dielectric material, a semiconductive material, or a combination thereof. The lower structure LS may include silicon, monocrystalline silicon, polysilicon, amorphous silicon, silicon germanium, monocrystalline silicon germanium, polycrystalline silicon germanium, carbon-doped silicon, epitaxial silicon, a combination thereof, or multilayers thereof. The lower structure LS may also include another semiconductor material such as germanium. The lower structure LS may also include a III-V group semiconductor substrate, for example, a compound semiconductor substrate such as GaAs.

In some embodiments, the lower structure LS may include a metal wiring structure, a dielectric structure, a conductive structure, a bonding pad structure, another memory, or a peripheral circuit portion. For example, the lower structure LS may include a structure in which the peripheral circuit portion, the metal wiring structure and the bonding pad structure are sequentially stacked. The memory cell array MCA and the peripheral circuit portion of the lower structure LS may be bonded by wafer bonding. The wafer bonding may include pad bonding, hybrid bonding, oxide-to-oxide bonding, metal-to-metal bonding, or a combination thereof.

Each of the memory cells MC may include a first conductive line BL, a switching element TR, and a data storage element CAP. The switching element TR may include a second conductive line WL, a nano sheet dielectric layer GD, and a nano sheet HL.

The semiconductor device 100 may include a column array AR1 of the memory cells MC and a row array AR2 of the memory cells MC. The column array AR1 may include a plurality of memory cells MC vertically stacked in a first direction D1. The memory cells MC in the column array AR1 may share the first conductive line BL. The row array AR2 may include a plurality of memory cells MC horizontally disposed in a third direction D3. The memory cells MC in the row array AR2 may share the second conductive line WL. The first direction D1 may be a vertical direction, and the third direction D3 may be a horizontal direction. The semiconductor device 100 may further include a horizontal level array AR3, which may include a plurality of memory cells MC disposed at the same horizontal level in a second direction D2. The memory cells MC adjacent to each other in the horizontal level array AR3 may share the first conductive line BL.

The semiconductor device 100 may include a horizontal arrangement of a plurality of first conductive lines BL and a vertical arrangement of a plurality of second conductive lines WL. A vertical arrangement of memory cells MC stacked in the first direction D1 may share one first conductive line BL. A horizontal arrangement of memory cells MC arranged in the third direction D3 may be coupled to different first conductive lines BL. The horizontal arrangement of memory cells MC arranged in the third direction D3 may share one second conductive line WL. The vertical arrangement of memory cells MC stacked in the first direction D1 may be coupled to different second conductive lines WL.

The semiconductor device 100 may include a first sub-cell array MCA1 and a second sub-cell array MCA2. The first sub-cell array MCA1 and the second sub-cell array MCA2 may each include a three-dimensional array of the memory cells MC. The first sub-cell array MCA1 and the second sub-cell array MCA2 may share the first conductive line BL. The first conductive line BL may include a first vertical conductive line BLA and a second vertical conductive line BLB. A bottom portion of the first vertical conductive line BLA and a bottom portion of the second vertical conductive line BLB may be merged with each other. The first conductive line BL may have a U shape formed by merging the first vertical conductive line BLA and the second vertical conductive line BLB. The memory cells MC of the first sub-cell array MCA1 may share the first vertical conductive line BLA, and the memory cells MC of the second sub-cell array MCA2 may share the second vertical conductive line BLB. In this way, the first and second sub-cell arrays MCA1 and MCA2 adjacent to each other in the second direction D2 may have a mirror-type structure of sharing the first conductive line BL. From the perspective of a top view, the first and second vertical conductive lines BLA and BLB may each have a rectangular shape.

A first inter-cell dielectric layer IL1 may be disposed between the data storage elements CAP adjacent to each other in the third direction D3. A second inter-cell dielectric layer IL2 may be disposed between the second conductive lines WL vertically stacked in the first direction D1. A third inter-cell dielectric layer IL3 may be disposed between first electrodes SN of the data storage elements CAP vertically stacked in the first direction D1. The first to third inter-cell dielectric layers IL1, IL2 and IL3 may each include silicon oxide, silicon carbon oxide (SiCO), silicon nitride, or a combination thereof. The first inter-cell dielectric layer IL1 may be referred to as a "device isolation layer".

The memory cell array MCA may further include a first contact node BLC and a second contact node SNC. The first contact node BLC may be disposed between the first and second vertical conductive lines BLA and BLB and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and a first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped polysilicon, and a second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of the channel CH in the first direction D1. The first and second contact nodes BLC and SNC may each include doped polysilicon, for example, phosphorus-doped polysilicon or arsenic-doped polysilicon.

The memory cell array MCA may further include an ohmic contact layer BLO between the first contact node BLC and the first conductive line BL. The ohmic contact layer BLO may include metal silicide, such as titanium silicide or molybdenum silicide.

As described above with reference to FIGS. 1A, 1B and 2B, a thickness of the first contact node BLC and a thickness of the ohmic contact layer BLO in the first direction D1 may be greater than a thickness of the nano sheet HL.

The memory cell array MCA may further include a first spacer SP1 and a second spacer SP2. The first spacer SP1 may be disposed between the second conductive line WL and the second doped region DR. The second spacer SP2 may be disposed between the first conductive line BL and the second conductive line WL. The first and second spacers SP1 and SP2 may each include a dielectric material. The first and second spacers SP1 and SP2 may each include silicon oxide, silicon nitride, or a combination thereof. As described above with reference to FIGS. 2B and 2C, the first and second spacers SP1 and SP2 may extend in the third direction D3 on both sidewalls of the second conductive line WL. The first and second spacers SP1 and SP2 may surround a horizontal arrangement of the nano sheets HL in the third direction D3. In addition, the first spacer SP1 may vertically extend in the first direction D1.

The memory cell array MCA may include a plurality of second conductive lines WL vertically stacked in the first direction D1. The memory cell array MCA may include a plurality of nano sheets HL vertically stacked in the first direction D1. The memory cell array MCA may include a plurality of data storage elements CAP vertically stacked in the first direction D1. The memory cell array MCA may include a plurality of first conductive lines BL spaced apart in the third direction D3. The memory cell array MCA may include a dummy second conductive line WLU disposed at a level higher than an uppermost second conductive line WL and a dummy second conductive line WLL disposed at a level lower than a lowermost second conductive line WL. The dummy second conductive lines WLU and WLL may each have a linear shape extending horizontally.

The memory cell array MCA may include a stack of a plurality of hard mask layers HM1, HM2 and HM3 disposed at a level higher than the uppermost second conductive line WL.

The memory cell array MCA may include a plurality of first and second bottom protection layers BT1 and BT2. The first bottom protection layer BT1 may prevent the first conductive lines BL and the lower structure LS from coming into electrical contact with each other. The second bottom protection layer BT2 may prevent the data storage element CAP and the lower structure LS from coming into electrical contact with each other. The first and second bottom protection layers BT1 and BT2 may each include a dielectric material.

An array isolation layer BLF may be disposed between the first vertical conductive line BLA and the second vertical conductive line BLB of the first conductive line BL. The array isolation layer BLF may include a dielectric material. For example, the array isolation layer BLF may include silicon oxide, silicon nitride, air gap-embedded silicon oxide, or a combination thereof.

The nano sheets HL of the switching elements TR horizontally disposed in the third direction D3 may share one second conductive line WL. The nano sheets HL of the switching elements TR horizontally disposed in the third direction D3 may be coupled to different first conductive lines BL. The switching elements TR stacked in the first direction D1 may share one first conductive line BL. The switching elements TR horizontally disposed in the third direction D3 may share one second conductive line WL.

Second electrodes PN of the data storage elements CAP may be coupled to a common plate PL. The second electrodes PN of the data storage elements CAP may be merged with each other and form a common plate PL.

Referring to FIG. 4C, the vertical arrangement of the second conductive lines WL and a vertical arrangement of the second inter-cell dielectric layers IL2 may be formed. Each of the second inter-cell dielectric layers IL2 may be disposed between the second conductive lines WL. The dummy second conductive line WLU disposed at a level higher than the uppermost second conductive line WL and the dummy second conductive line WLL disposed at a level lower than the lowermost second conductive line WL may be included. The dummy second conductive lines WLU and WLL may each have a linear shape extending horizontally.

The nano sheet dielectric layers GD may surround the nano sheets HL, and the second conductive lines WL may surround the nano sheets HL on the nano sheet dielectric layers GD.

Each of the nano sheet dielectric layers GD may include a deposition portion GD1 and an oxidation portion GD2. Forming the nano sheet dielectric layer GD may include forming the deposition portion GD1 and performing an oxidation process to form the oxidation portion GD2. While the oxidation portion GD2 is formed, the deposition portion GD1 may be re-oxidized. In an embodiment, the deposition portion GD1 and the oxidation portion GD2 of the nano sheet dielectric layer GD may be silicon oxide. In some embodiments, the deposition portion GD1 of the nano sheet dielectric layer GD may be metal oxide, and the oxidation portion GD2 may be silicon oxide. In some embodiments, the deposition portion GD1 of the nano sheet dielectric layer GD may include silicon nitride, metal oxynitride, metal silicate, a high-k material, a ferroelectric material, an anti-ferroelectric material, or a combination thereof. The nano sheet dielectric layer GD may include SiO₂, Si₃N₄, HfO₂, Al₂O₃, ZrO₂, AlON, HfON, HfSiO, HfSiON, or a combination thereof.

The nano sheet dielectric layer GD may be formed on all surfaces of the nano sheets HL.

As will be described below, because the oxidation portion GD2 of the nano sheet dielectric layer GD is formed by oxidation of a sheet expansion layer, a gap HG between the nano sheets HL disposed at the same horizontal level may be reduced.

In an embodiment, because the gap HG between the nano sheets HL disposed at the same horizontal level is small, a self-alignment contact margin of the second conductive lines WL may be improved. In addition, in an embodiment, a width of the nano sheets HL may increase, so that an occupied area of the channel CH may also increase. When the occupied area of the channel CH increases, characteristics of the switching element TR may be improved.

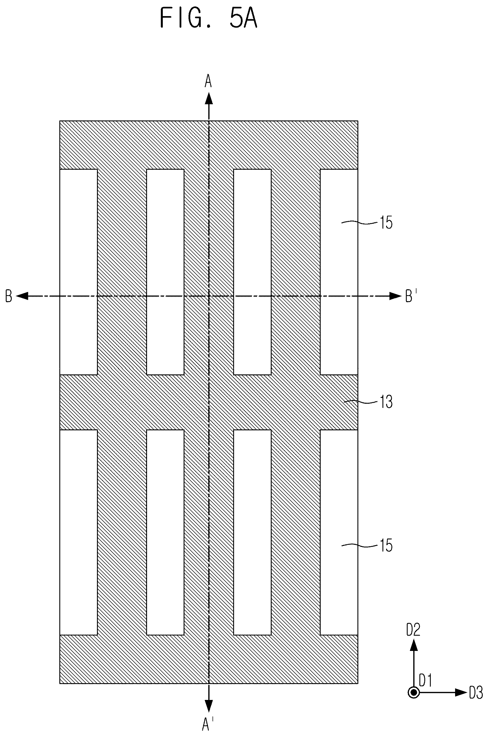

FIGS. 5A to 28B illustrate various views of a semiconductor device formed utilizing a method for fabricating the semiconductor device in accordance with an embodiment of the present disclosure.

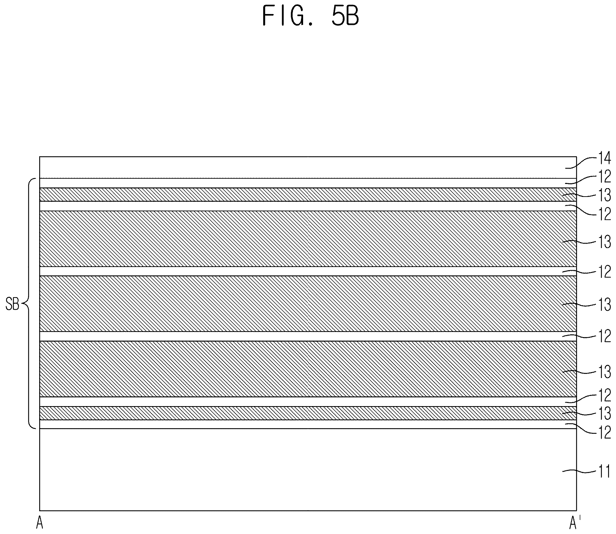

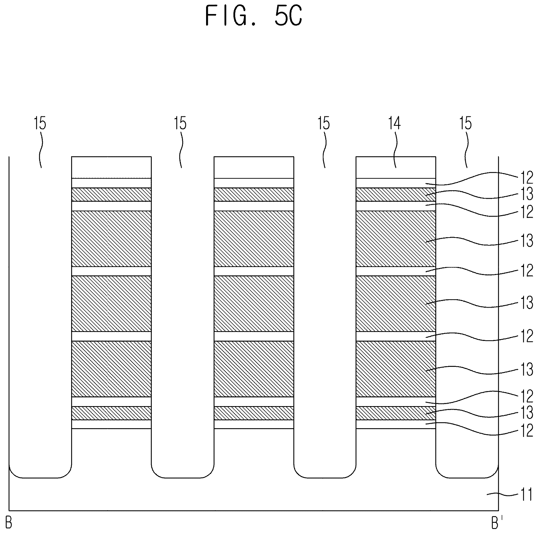

FIG. 5A is a plan view illustrating a structure at a second mold layer level to describe a method for forming a mold stack SB. FIG. 5B is a cross-sectional view of the structure taken along line A-A' illustrated in FIG. 5A. FIG. 5C is a cross-sectional view of the structure taken along line B-B' illustrated in FIG. 5A.

Referring to FIGS. 5A to 5C, the mold stack SB may be formed on a substrate 11. The substrate 11 may be a material appropriate for semiconductor processing. The substrate 11 may include a semiconductor substrate, a conductive material, a dielectric material, a semiconductive material, or a combination thereof. The substrate 11 may include silicon, monocrystalline silicon, polysilicon, amorphous silicon, silicon germanium, monocrystalline silicon germanium, polycrystalline silicon germanium, carbon-doped silicon, epitaxial silicon, a combination thereof, or multilayers thereof. The substrate 11 may also include another semiconductor material such as germanium. The substrate 11 may also include a III-V group semiconductor substrate, for example, a compound semiconductor substrate such as GaAs. The mold stack SB may include an alternating stack of first mold layers 12 and second mold layers 13.

To form the mold stack SB, the first mold layers 12 may be alternately stacked with the second mold layers 13, and the first mold layers 12 and the second mold layers 13 may be epitaxially grown multiple times. The first mold layers 12 and the second mold layers 13 may be different semiconductive materials. The first mold layers 12 may each include silicon germanium or monocrystalline silicon germanium. The second mold layers 13 may each include monocrystalline silicon. The first mold layers 12 and the second mold layers 13 may be formed by an epitaxial growth process. A lowermost first mold layer 12 may serve as a seed layer during the epitaxial growth process. Each of the first mold layers 12 may be thinner than each of the second mold layers 13. The first mold layers 12 may include first epitaxially grown layers, and the second mold layers 13 may include second epitaxially grown layers.

In an embodiment, a plurality of silicon germanium layers may be alternately stacked with a plurality of monocrystalline silicon layers in the mold stack SB. For example, a stack of a silicon germanium layer and a monocrystalline silicon layer (a SiGe/Si stack) may be stacked multiple times.
The first mold layers 12 may be referred to as "sacrificial layers", and the second mold layers 13 may be referred to as "nano sheet target layers" or "recess target layers". Lowermost and uppermost layers of the mold stack SB may be the first mold layers 12.

The mold stack SB may be referred to as a "vertical stack". The mold stack SB may be formed by alternately stacking a plurality of sacrificial layers and a plurality of nano sheet target layers. The sacrificial layers may be silicon germanium layers, and the nano sheet target layers may be monocrystalline silicon layers.

A ratio of a thickness of the first mold layers 12 to a thickness of the second mold layers 13 in the mold stack SB may be variously modified. For example, the thickness of the first mold layers 12 may be 5 to 20 nm, and the thickness of the second mold layers 13 may be 50 to 80 nm. A quantity of the first mold layers 12 and a quantity of the second mold layers 13 in the mold stack SB may be variously modified. In some embodiments, a triple stack including the first mold layer 12, the second mold layer 13 and the first mold layer 12 may be defined at lowermost and uppermost portions of the mold stack SB. The second mold layer 13 of the triple stack may have a thickness less than the other second mold layers 13.

A first hard mask layer 14 may be formed on the mold stack SB. The first hard mask layer 14 may include a dielectric material such as an oxide-based material, a nitride-based material, a carbon-based material, or a combination thereof. For example, the first hard mask layer 14 may include SiO₂, Si₃N₄, amorphous carbon, or a combination thereof.

Subsequently, portions of the mold stack SB may be etched using the first hard mask layer 14 as a barrier, and a plurality of sacrificial isolation openings 15 may be formed. The sacrificial isolation openings 15 may be initial openings for cell isolation. From the perspective of a top view, cross-sections of the sacrificial isolation openings 15 may each have a rectangular shape. In some embodiments, the cross-sections of the sacrificial isolation openings 15 may each have a circular shape or an oval shape. In some embodiments, the sacrificial isolation openings 15 may be referred to as "sacrificial isolation trenches". The sacrificial isolation openings 15 may vertically extend in a first direction D1 and extend lengthwise in a second direction D2. The sacrificial isolation openings 15 may be disposed at a predetermined interval in a third direction D3. A bottom surface of each of the sacrificial isolation openings 15 may extend inside of the substrate 11.

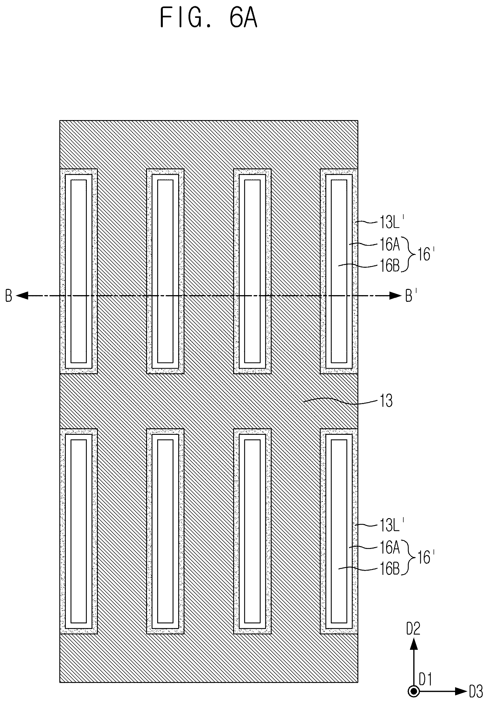

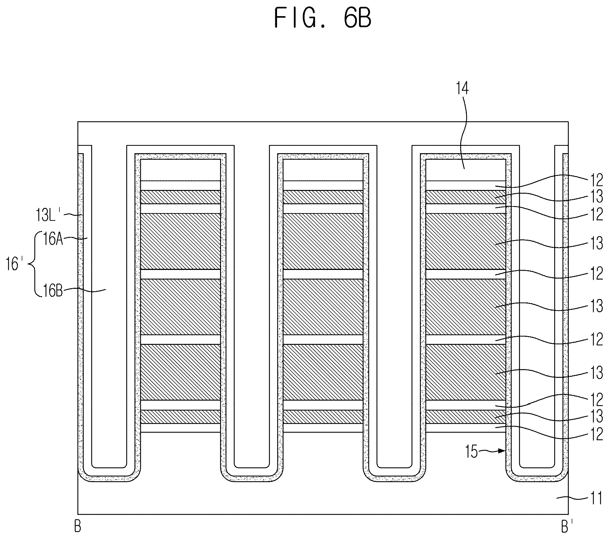

FIG. 6A is a plan view illustrating the structure at the second mold layer level to describe a method for forming a preliminary sheet expansion layer 13L'. FIG. 6B is a cross-sectional view of the structure taken along line B-B' illustrated in FIG. 6A.

Referring to FIGS. 6A and 6B, the preliminary sheet expansion layer 13L' may be conformally formed on the sacrificial isolation openings 15 and the first hard mask layer 14. The preliminary sheet expansion layer 13L' may include polysilicon. The preliminary sheet expansion layer 13L' may be epi-like polysilicon. The epi-like polysilicon may refer to polysilicon grown with the same crystallinity as an epitaxial layer. After the preliminary sheet expansion layer 13L' is formed, an annealing process may be performed, and the crystallinity may be strengthened by the annealing process. In some embodiments, the preliminary sheet expansion layer 13L' may be referred to as a "polysilicon liner". The formation of the epi-like polysilicon may be similar to a general deposition process of polysilicon. For example, the epi-like polysilicon may refer to a material epitaxially grown on monocrystalline silicon when polysilicon is deposited in a thin thickness. A thickness of the preliminary sheet expansion layer 13L' may be 30 to 45 Å.

A preliminary sacrificial isolation layer 16' may be formed on the preliminary sheet expansion layer 13L' to fill the sacrificial isolation openings 15. The preliminary sacrificial isolation layer 16' may include the same material. The preliminary sacrificial isolation layer 16' may be formed of a dielectric material. The preliminary sacrificial isolation layer 16' may have an etch selectivity with respect to the mold stack SB. For example, the preliminary sacrificial isolation layer 16' may include silicon oxide, silicon nitride, silicon carbon oxide, silicon carbon nitride, or a combination thereof. Forming the preliminary sacrificial isolation layer 16' may include forming sacrificial isolation materials on the mold stack SB to fill the sacrificial isolation openings 15. Forming the preliminary sacrificial isolation layer 16' may include conformally forming a sacrificial isolation liner layer 16A on the preliminary sheet expansion layer 13L' and forming a sacrificial isolation gap-fill layer 16B filling the sacrificial isolation openings 15 on the sacrificial isolation liner layer 16A. The sacrificial isolation liner layer 16A may be silicon nitride, and the sacrificial isolation gap-fill layer 16B may be silicon oxide.

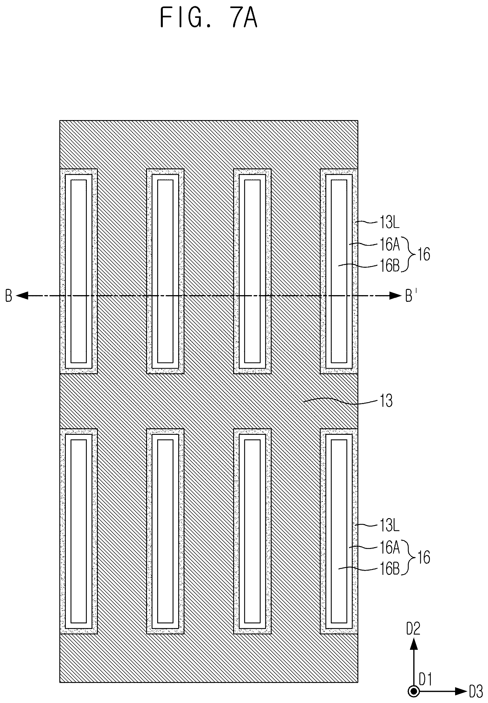

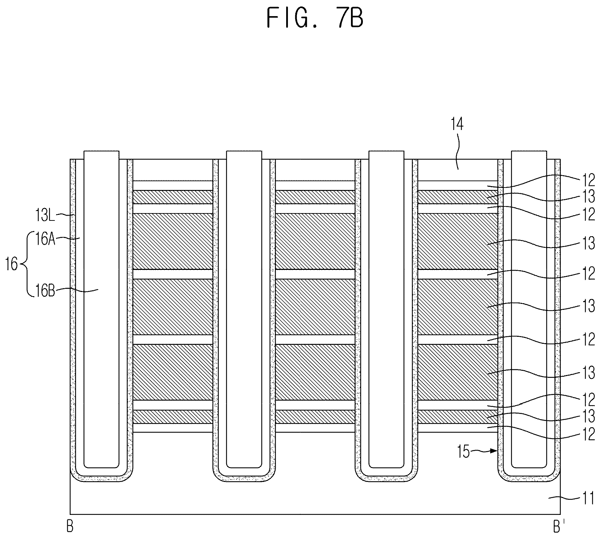

FIG. 7A is a plan view illustrating the structure at the second mold layer level to describe a method for forming sheet expansion layers 13L and sacrificial isolation layers 16. FIG. 7B is a cross-sectional view of the structure taken along line B-B' illustrated in FIG. 7A.

Referring to FIGS. 7A and 7B, the preliminary sacrificial isolation layer 16' may be selectively etched to form a plurality of sacrificial isolation layers 16. For example, planarizing the sacrificial isolation gap-fill layer 16B and exposing the sacrificial isolation liner layer 16A to a cleaning process may be sequentially performed. Each of the sacrificial isolation layers 16 may include a stack of the sacrificial isolation liner layer 16A and the sacrificial isolation gap-fill layer 16B.

Subsequently, the preliminary sheet expansion layer 13L' may be exposed to a cleaning process to form the sheet expansion layers 13L.

An upper surface of the sacrificial isolation gap-fill layer 16B may be at a higher level than an upper surface of the sacrificial isolation liner layer 16A. The upper surface of the sacrificial isolation liner layer 16A may be at a higher level than upper surfaces of the sheet expansion layers 13L. The upper surface of the sacrificial isolation gap-fill layer 16B may be at a higher level than an upper surface of the first hard mask layer 14. A portion of the first hard mask layer 14 may be recessed during the cleaning processes for forming the sacrificial isolation liner layer 16A and the sheet expansion layers 13L. The upper surfaces of the sacrificial isolation liner layer 16A, the sheet expansion layers 13L and the first hard mask layer 14 may be at the same level.

The sacrificial isolation layers 16 may vertically extend in the first direction D1 and extend lengthwise in the second direction D2. The sacrificial isolation layers 16 may be disposed at a predetermined interval in the third direction D3.

Each of the sheet expansion layers 13L may be disposed in a different one of the sacrificial isolation openings 15. The sheet expansion layers 13L may be coupled in common to the first and second mold layers 12 and 13. The sheet expansion layers 13L may each include a U-shaped outer surface formed in the sacrificial isolation openings 15. The U-shaped outer surfaces of the sheet expansion layers 13L may be coupled in common to the second mold layers 13 stacked in the first direction D1. The U-shaped outer surfaces of the sheet expansion layers 13L may be coupled in common to the second mold layers 13 adjacent to each other in the second direction D2. From the perspective of a top view, each of the sheet expansion layer 13L may have a closed loop shape of surrounding side surfaces of each of the sacrificial isolation openings 15.

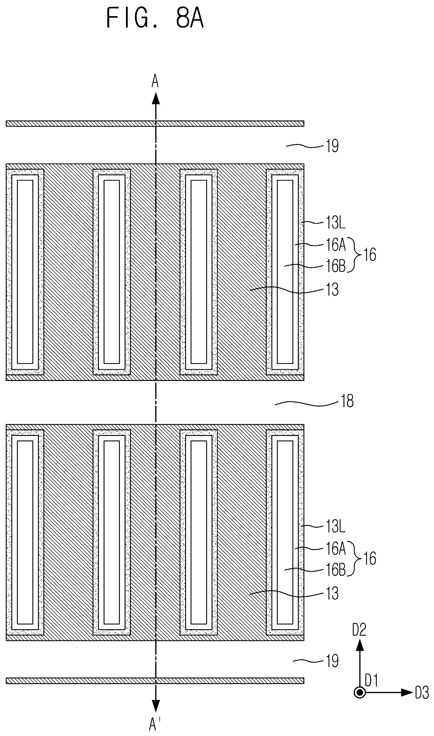

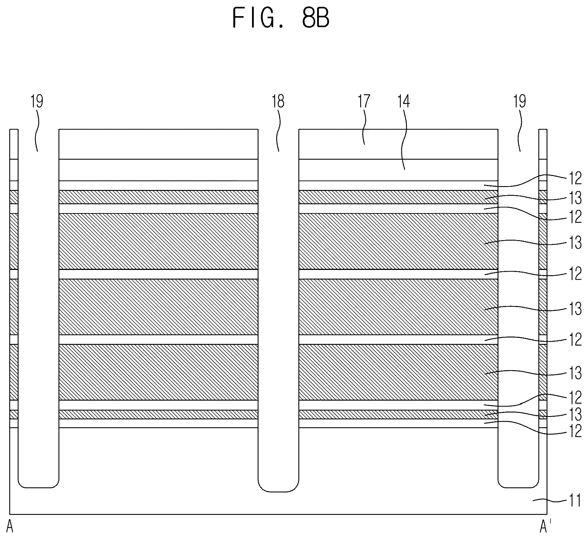

FIG. 8A is a plan view illustrating the structure at the second mold layer level to describe a method for forming sacrificial linear openings 18 and 19. FIG. 8B is a cross-sectional view of the structure taken along line A-A' illustrated in FIG. 8A.

Referring to FIGS. 8A and 8B, a second hard mask layer 17 may be formed on the mold stack SB and the sacrificial isolation layers 16. The second hard mask layer 17 may include silicon nitride. The second hard mask layer 17 may be formed by etching a second hard mask material using a mask layer such as photoresist. The second hard mask layer 17 may have a plurality of line-shaped openings defined therein.

Portions of the mold stack SB may be etched using the second hard mask layer 17 as an etch barrier. Accordingly, a plurality of sacrificial linear openings 18 and 19 may be formed between the sacrificial isolation layers 16. The sacrificial linear openings may include a first sacrificial linear opening 18 and a second sacrificial linear opening 19. From the perspective of a top view, the first sacrificial linear opening 18 and the second sacrificial linear opening 19 may be line-shaped openings extending in the third direction D3. The first sacrificial linear opening 18 and the second sacrificial linear opening 19 may vertically extend in the first direction D1. The sacrificial isolation layers 16 may be disposed between the first sacrificial linear opening 18 and the second sacrificial linear opening 19 in the second direction D2. From the perspective of a top view, cross sections of the first and second sacrificial linear openings 18 and 19 may each have a rectangular shape. In some embodiments, the cross sections of the first and second sacrificial linear openings 18 and 19 may each have a circular shape or an oval shape. The first and second sacrificial linear openings 18 and 19 may each have a width in the second direction D2 which is less than a width in the third direction D3. The first and second sacrificial linear openings 18 and 19 may be referred to as "sacrificial linear trenches". The first sacrificial linear opening 18 and the second sacrificial linear opening 19 may have different horizontal lengths in the third direction D3.

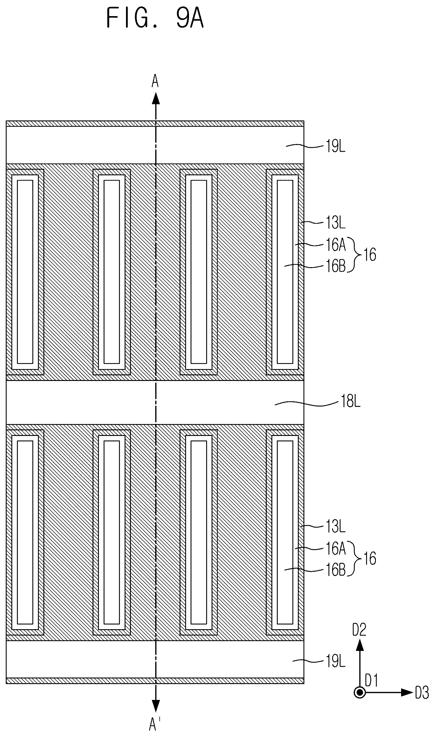

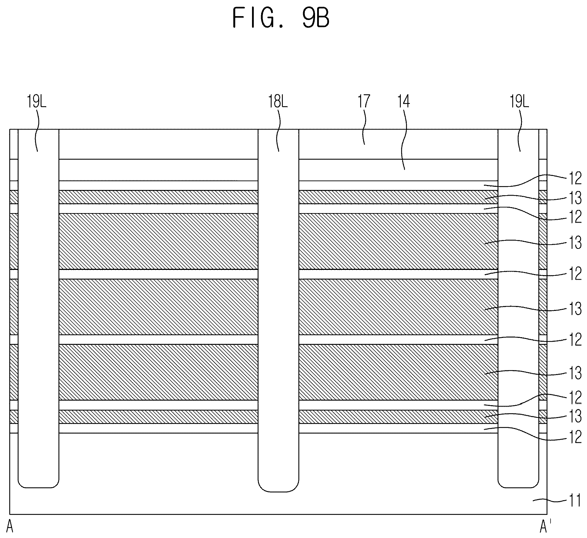

FIG. 9A is a plan view illustrating the structure at the second mold layer level to describe a method for forming linear sacrificial layers 18L and 19L. FIG. 9B is a cross-sectional view of the structure taken along line A-A' illustrated in FIG. 9A.

Referring to FIGS. 9A and 9B, the linear sacrificial layers 18L and 19L may be formed to fill the first and second sacrificial linear openings 18 and 19. The linear sacrificial layers may include a first linear sacrificial layer 18L and a second linear sacrificial layer 19L. From the perspective of a top view, the first linear sacrificial layer 18L and the second linear sacrificial layer 19L may have line shapes extending in the third direction D3. The first linear sacrificial layer 18L and the second linear sacrificial layer 19L may vertically extend in the first direction D1. The sacrificial isolation layers 16 may be disposed between the first linear sacrificial layer 18L and the second linear sacrificial layer 19L in the second direction D2. From the perspective of a top view, cross sections of the first and second linear sacrificial layers 18L and 19L may each have a rectangular shape. In some embodiments, the cross-sections of the first and second linear sacrificial layers 18L and 19L may each have a circular shape or an oval shape. The first and second linear sacrificial layers 18L and 19L may include the same material. The first and second linear sacrificial layers 18L and 19L may be each formed of a dielectric material. For example, the first and second linear sacrificial layers 18L and 19L may each include silicon oxide, silicon nitride, silicon carbon oxide, silicon carbon nitride, or a combination thereof. The sacrificial isolation layers 16 may not contact the first and second linear sacrificial layers 18L and 19L.

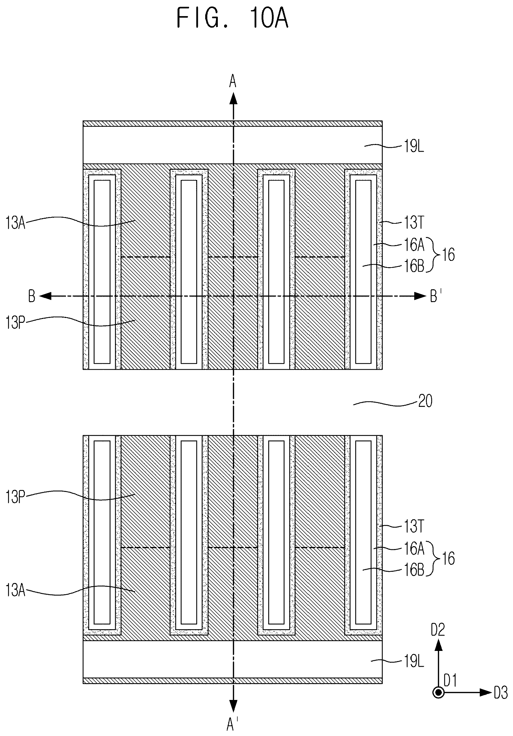

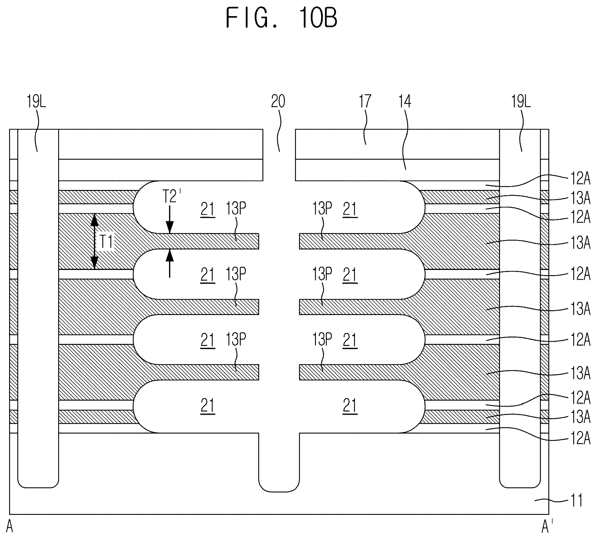

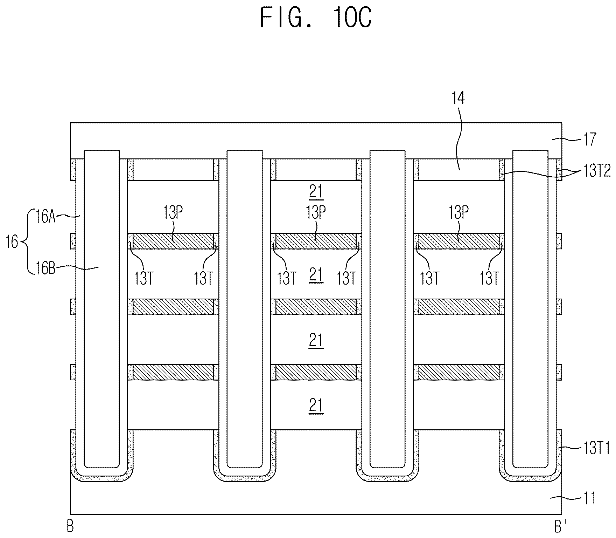

FIG. 10A is a plan view illustrating the structure at the second mold layer level to describe recessing of the first and second mold layers 12 and 13. FIG. 10B is a cross-sectional view of the structure taken along line A-A' illustrated in FIG. 10A. FIG. 10C is a cross-sectional view of the structure taken along line B-B' illustrated in FIG. 10A.

Referring to FIGS. 10A to 10C, among the first linear sacrificial layer 18L and the second linear sacrificial layer 19L, the first linear sacrificial layer 18L may be selectively removed. Accordingly, a first linear opening 20 may be formed. From the perspective of a top view, the first linear opening 20 may be disposed horizontally spaced apart from the second linear sacrificial layer 19L in the second direction D2.

Subsequently, the first mold layers 12 may be selectively recessed through the first linear opening 20.

A difference in etch selectivity between the first mold layers 12 and the second mold layers 13 may be used to selectively recess the first mold layers 12. The first mold layers 12 may be removed using a wet etch process or a dry etch process. For example, when the first mold layers 12 include silicon germanium layers, and the second mold layers 13 include monocrystalline silicon layers, the silicon germanium layers may be etched using an etchant or etch gas having a selectivity with respect to the monocrystalline silicon layers. The first mold layers each having an original thickness may remain as indicated by reference numeral "12A".

Subsequently, a portion (a first portion) of each of the second mold layers 13 may be recessed to form an initial sheet 13P. The wet etch process or dry etch process may be used to recess the second mold layers 13. An original body portion 13A and the initial sheet 13P may be formed by the partial recessing of each of the second mold layers 13. The original body portion 13A may maintain an original thickness T1, and the initial sheet 13P may have a thickness T2' less than the original thickness T1. A horizontal length of the original body portion 13A in the second direction D2 may be to the same as or different from a horizontal length of the initial sheet 13P in the second direction D2. A combination of the original body portion 13A and the initial sheet 13P may be referred to as a "preliminary active layer". The initial sheet 13P may be referred to as a "flat plate-shaped sheet" or a "protruding narrow sheet".

A recess process for forming the initial sheet 13P may be referred to as a "thinning process" or "trimming process" of the second mold layer 13. To form the initial sheet 13P, an upper surface, lower surface and side surface of the second mold layer 13 may be recessed. The initial sheet 13P may be referred to as a "thin-body active layer". The initial sheet 13P may include a monocrystalline silicon layer. The recess process for forming the initial sheet 13P may use, for example, Hot SC-1 (HSC1). The HSC1 may include a solution in which ammonium hydroxide (NH₄OH), hydrogen peroxide (H₂O₂) and water (H₂O) are mixed in a ratio of 1:4:20. Using the HSC1, the second mold layers 13 may be selectively etched.

The initial sheets 13P may be formed by the partial recess process for the second mold layers 13 as described above. Each of inter-nano sheet recesses 21 may be formed between the initial sheets 13P that are vertically disposed. Upper and lower surfaces of each of the initial sheets 13P may each include a flat surface. A boundary portion between the original body portion 13A and the initial sheet 13P may be vertical or have a curvature. Each of the first mold layers 12A may be disposed between the original body portions 13A that are vertically stacked.

While or after the second mold layers 13 are partially recessed, a portion of each of the sheet expansion layers 13L may be cut. Accordingly, sheet expansion tabs 13T may be formed at both ends of each of the initial sheets 13P in the third direction D3. A lower sheet expansion tab 13T1 may be formed in the substrate 11, and an upper sheet expansion tab 13T2 adjacent to the first hard mask layer 14 may be formed.

Combinations of the initial sheets 13P and the sheet expansion tabs 13T may be referred to as "nano sheet target patterns". The nano sheet target patterns may be vertically arranged in the first direction D1 and horizontally arranged in the third direction D3. That is, as the initial sheets 13P and the sheet expansion tabs 13T are formed, a horizontal arrangement and vertical arrangement of the nano sheet target patterns may be formed.

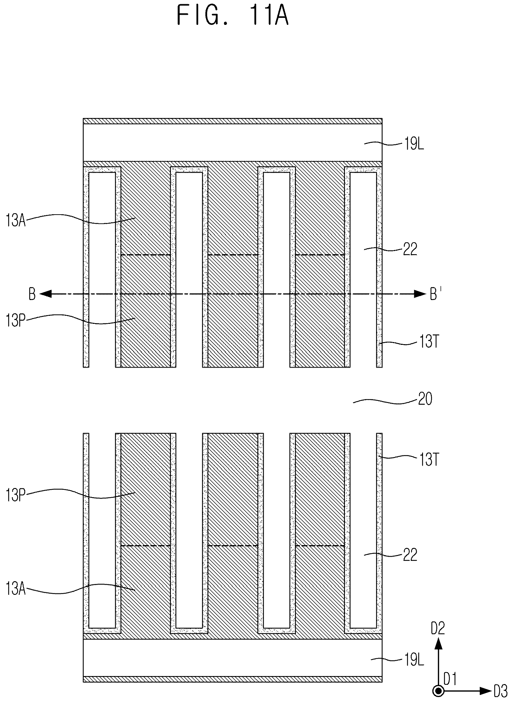

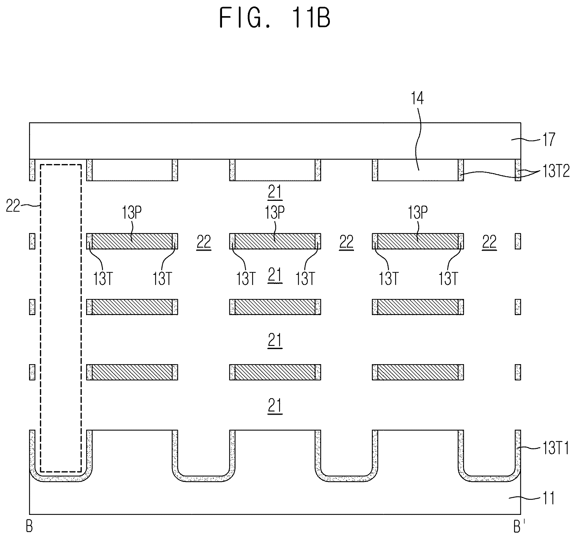

FIG. 11A is a plan view illustrating the structure at a narrow sheet level to describe a method for forming sacrificial isolation layer-level openings 22. FIG. 11B is a cross-sectional view of the structure taken along line B-B' illustrated in FIG. 11A.

Referring to FIGS. 11A and 11B, the sacrificial isolation layers 16 may be selectively stripped through the inter-nano sheet recesses 21. Accordingly, each of the sacrificial isolation layer-level openings 22 may be formed between the original body portions 13A in the third direction D3.

Side surfaces of the first mold layers 12A, side surfaces of the original body portions 13A and side surfaces of the initial sheets 13P may be exposed in the third direction D3 by the sacrificial isolation layer-level openings 22.

After the sacrificial isolation layer-level openings 22 are formed, the sheet expansion tabs 13T may remain at both ends of each of the initial sheets 13P in the third direction D3. A portion of each of the sacrificial isolation layer-level openings 22 may be formed between the combinations of the initial sheets 13P and the sheet expansion tabs 13T, i.e., the nano sheet target patterns arranged horizontally.

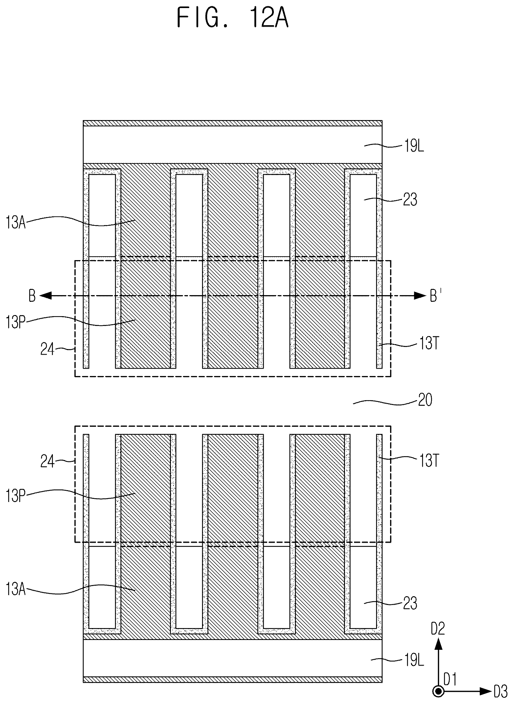

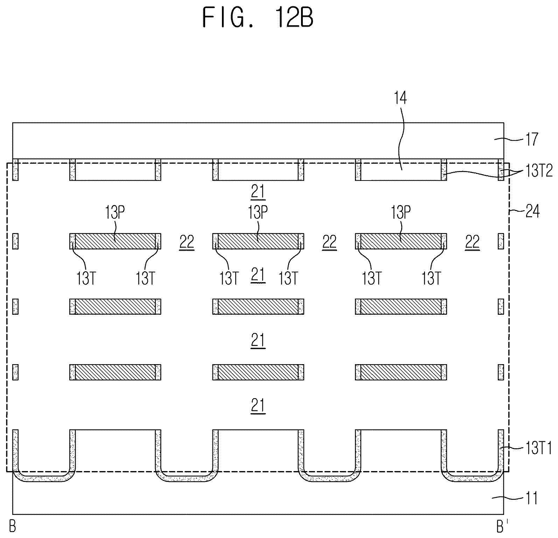

FIG. 12A is a plan view illustrating the structure at the narrow sheet level to describe a method for forming first inter-cell dielectric layers 23. FIG. 12B is a cross-sectional view of the structure taken along line B-B' illustrated in FIG. 12A.

Referring to FIGS. 12A and 12B, the first inter-cell dielectric layers 23 may be formed in the sacrificial isolation layer-level openings 22. The first inter-cell dielectric layers 23 may each include a dielectric material. The first inter-cell dielectric layers 23 may each include silicon oxide, silicon nitride, silicon carbon oxide, or a combination thereof. Forming the first inter-cell dielectric layers 23 may include forming a dielectric material that fills the sacrificial isolation layer-level openings 22 and performing an etch-back process on the dielectric material.

The first inter-cell dielectric layers 23 may fill portions of the sacrificial isolation layer-level openings 22. The side surfaces of the first mold layers 12A and the side surfaces of the original body portions 13A may be covered by the first inter-cell dielectric layers 23 in the third direction D3. The first inter-cell dielectric layers 23 may expose the side surfaces of the initial sheets 13P. The other portions of the sacrificial isolation layer-level openings 22, i.e., non-gap-filled portions, may expose the side surfaces of the initial sheets 13P. The non-gap-filled portions may be defined between the initial sheets 13P in the third direction D3.

After the first inter-cell dielectric layers 23 are formed, a nano sheet all-open recess 24 that opens all of the initial sheets 13P may be formed. The nano sheet all-open recess 24 may refer to a combination of the inter-nano sheet recesses 21 and the non-gap-filled portions of the first inter-cell dielectric layers 23. The nano sheet all-open recess 24 may expose a plurality of initial sheets 13P in the third direction D3.

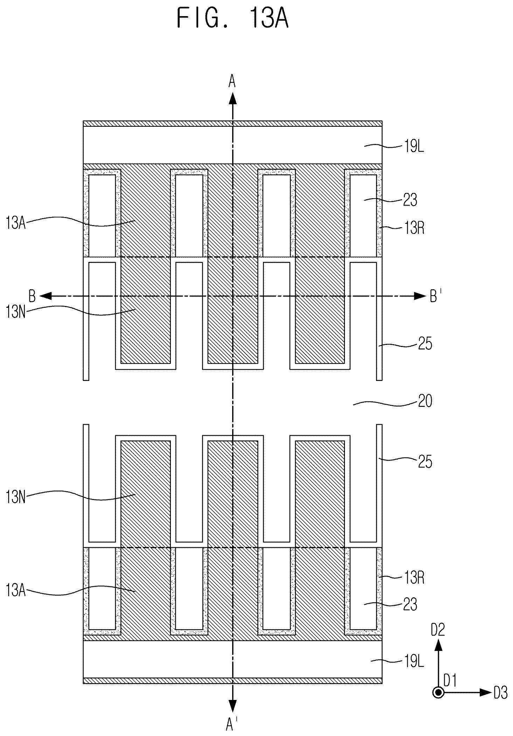

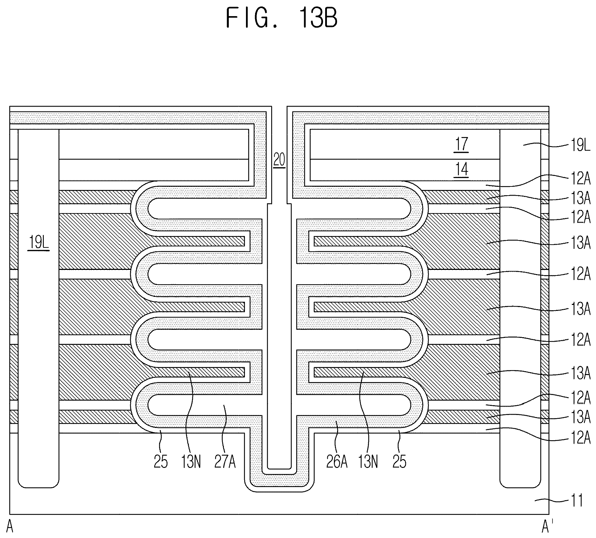

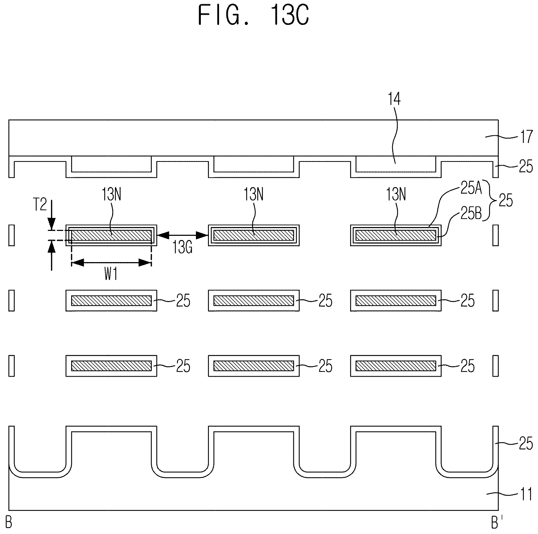

FIG. 13A is a plan view illustrating the structure at the narrow sheet level to describe a method for forming a nano sheet dielectric layer 25. FIG. 13B is a cross-sectional view of the structure taken along line A-A' illustrated in FIG. 13A. FIG. 13C is a cross-sectional view of the structure taken along line B-B' illustrated in FIG. 13A.

Referring to FIGS. 13A to 13C, the nano sheet target patterns may be exposed to a surface treatment. That is, the initial sheets 13P and the sheet expansion tabs 13T may be exposed to the surface treatment. Accordingly, narrow sheets 13N and the nano sheet dielectric layer 25 surrounding the narrow sheets 13N may be formed. The nano sheet dielectric layer 25 may be referred to as a "gate dielectric layer". The surface treatment may include a deposition process and an oxidation process. The nano sheet dielectric layer 25 may surround each of the narrow sheets 13N. The narrow sheets 13N may be vertically arranged in the first direction D1 and horizontally arranged in the third direction D3. That is, after the nano sheet dielectric layer 25 is formed, a vertical arrangement and horizontal arrangement of the narrow sheets 13N may be formed.

The nano sheet dielectric layer 25 may include a deposition portion 25A and an oxidation portion 25B. Forming the nano sheet dielectric layer 25 may include forming the deposition portion 25A on the initial sheet 13P and the sheet expansion tab 13T and performing an oxidation process on the initial sheet 13P and the sheet expansion tab 13T to form the oxidation portion 25B. While the oxidation portion 25B is formed, the deposition portion 25A may be re-oxidized. In an embodiment, the deposition portion 25A and the oxidation portion 25B of the nano sheet dielectric layer 25 may be silicon oxide. In some embodiments, the deposition portion 25A of the nano sheet dielectric layer 25 may be metal oxide, and the oxidation portion 25B may be silicon oxide. In some embodiments, the deposition portion 25A of the nano sheet dielectric layer 25 may include silicon nitride, metal oxynitride, metal silicate, a high-k material, a ferroelectric material, an anti-ferroelectric material, or a combination thereof. The nano sheet dielectric layer 25 may include SiO₂, Si₃N₄, HfO₂, Al₂O₃, ZrO₂, AlON, HfON, HfSiO, HfSiON, or a combination thereof.

While the nano sheet dielectric layer 25 is formed, sizes of the initial sheets 13P may be reduced. Accordingly, the narrow sheets 13N may be formed. The narrow sheets 13N may each have a sheet thickness T2, and the sheet thickness T2 may be less than the thickness (reference symbol "T2" in FIG. 10C) of the initial sheet 13P.

The nano sheet dielectric layer 25 may be formed on all surfaces of the narrow sheets 13N. The sheet expansion tab 13T that contacts the first inter-cell dielectric layers 23 may remain as a dummy sheet expansion tab 13R. That is, while the nano sheet dielectric layer 25 is formed, the dummy sheet expansion tab 13R may not be exposed to the deposition and oxidation processes by the first inter-cell dielectric layers 23.

Because the oxidation portion 25B of the nano sheet dielectric layer 25 is formed by the oxidation of the sheet expansion tab 13T, a gap 13G between the narrow sheets 13N may be reduced.

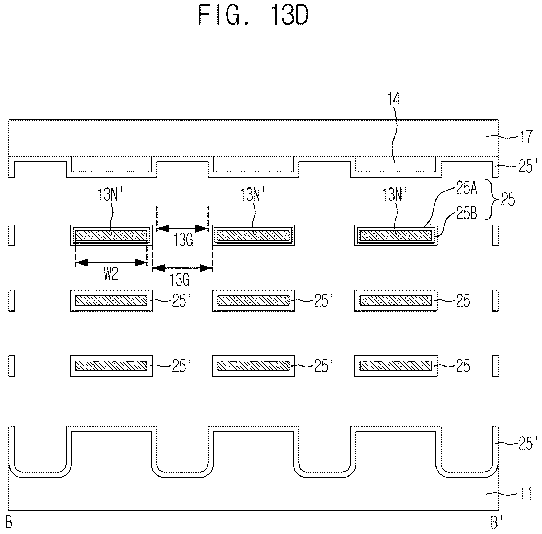

FIG. 13D is a view illustrating the structure to describe a method for forming a nano sheet dielectric layer 25' according to a comparative example. Referring to FIG. 13D, in the comparative example, the nano sheet dielectric layer 25' may be formed on a preliminary narrow sheet 13P without a sheet expansion tab. The nano sheet dielectric layer 25' may include a deposition portion 25A' and an oxidation portion 25B'. Forming the nano sheet dielectric layer 25' may include forming the deposition portion 25A' on the preliminary narrow sheet 13P and oxidizing surfaces of the preliminary narrow sheet 13P to form the oxidation portion 25B'. While the nano sheet dielectric layer 25' is formed, sizes of the preliminary narrow sheet 13P may be reduced. Accordingly, narrow sheets 13N' of the comparative example may be formed, and the nano sheet dielectric layer 25' may be formed on all surfaces of the narrow sheets 13N'.

A gap 13G' between the narrow sheets 13N' according to the comparative example may be greater than the gap 13G between the narrow sheets 13N according to an embodiment. A width W2 of each of the narrow sheets 13N' according to the comparative example may be less than a width W1 of each of the narrow sheets 13N according to an embodiment.

In an embodiment, because the oxidation portion 25B of the nano sheet dielectric layer 25 is formed by the oxidation of the sheet expansion tab 13T, the gap 13G between the narrow sheets 13N may be reduced.

In an embodiment, because the gap 13G between the narrow sheets 13N is reduced, a self-alignment contact margin of subsequent horizontal conductive lines may be improved. In addition, in an embodiment, because the occupied area of the channel increases as the widths of the narrow sheets 13N increase, characteristics of a switching element, i.e., a cell transistor, may be improved.

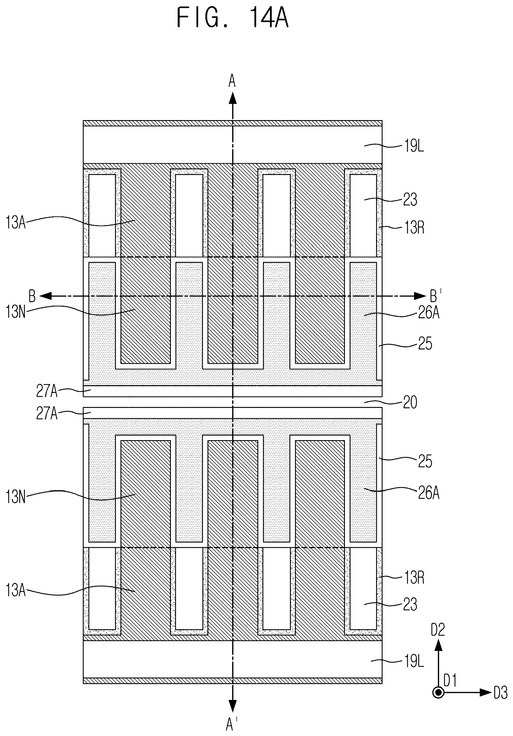

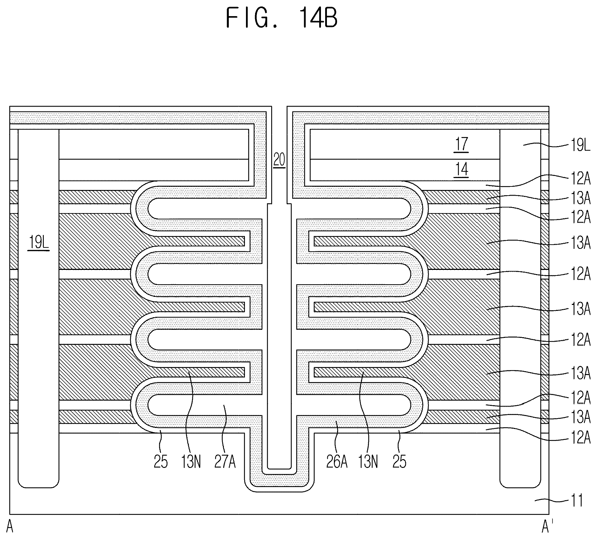

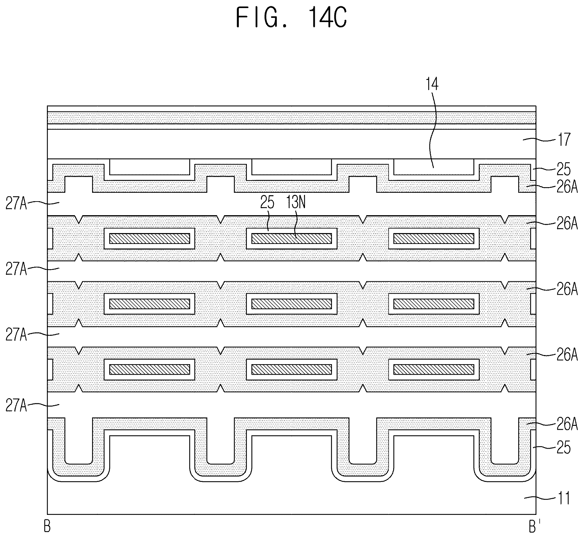

FIG. 14A is a plan view illustrating the structure at the narrow sheet level to describe a method for forming a first spacer layer 26A. FIG. 14B is a cross-sectional view of the structure taken along line A-A' illustrated in FIG. 14A. FIG. 14C is a cross-sectional view of the structure taken along line B-B' illustrated in FIG. 14A.

Referring to FIGS. 14A to 14C, the first spacer layer 26A may be formed on the nano sheet dielectric layer 25. The first spacer layer 26A may include silicon nitride. The first spacer layer 26A may surround and cover the narrow sheets 13N on the nano sheet dielectric layer 25. The first spacer layer 26A may be thicker than the nano sheet dielectric layer 25.

Second inter-cell dielectric layers 27A may be formed on the first spacer layer 26A. The second inter-cell dielectric layers 27A may each include silicon oxide.

The nano sheet dielectric layer 25 and the first spacer layer 26A may also be formed on the surface of the substrate 11.

As described above, the first spacer layer 26A may be disposed between the narrow sheets 13N in the third direction D3.

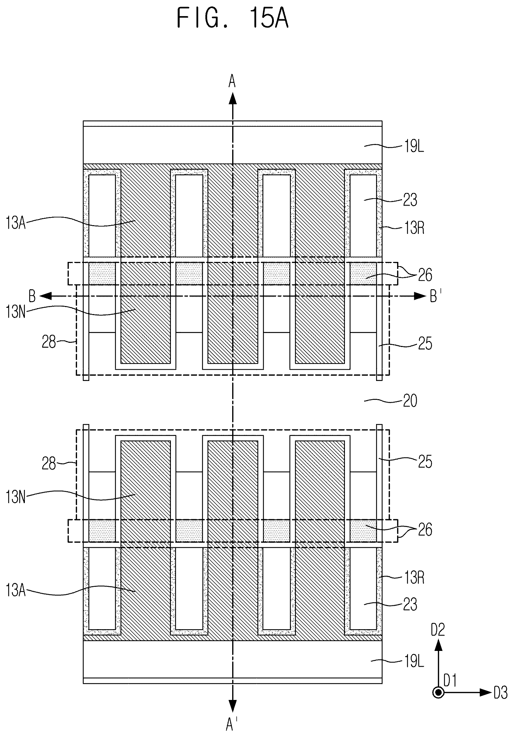

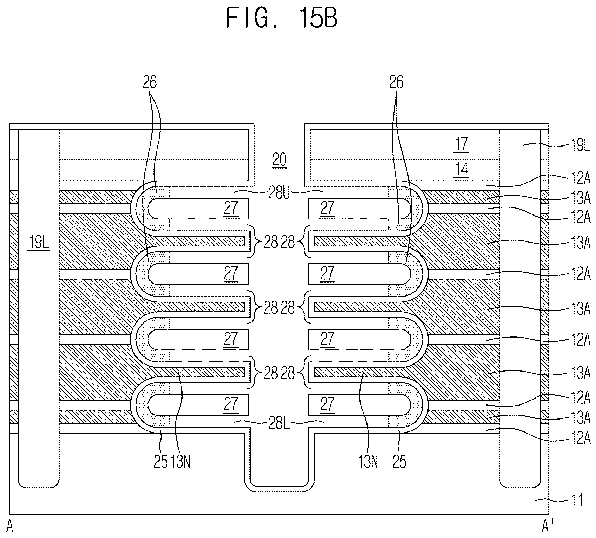

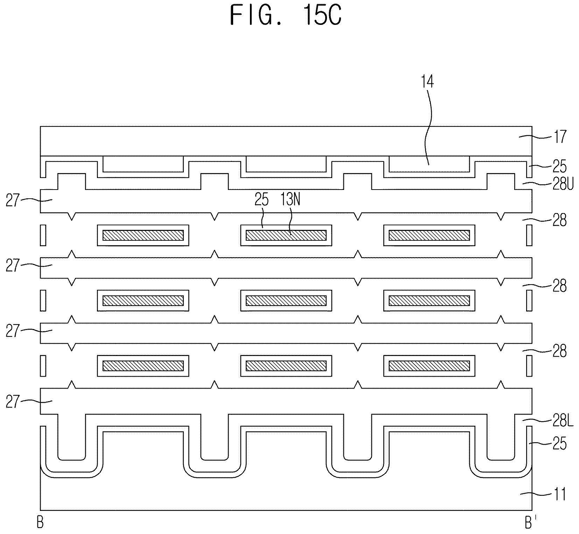

FIG. 15A is a plan view illustrating the structure at the narrow sheet level to describe a method for forming first spacers 26. FIG. 15B is a cross-sectional view of the structure taken along line A-A' illustrated in FIG. 15A. FIG. 15C is a cross-sectional view of the structure taken along line B-B' illustrated in FIG. 15A.

Referring to FIGS. 15A to 15C, the second inter-cell dielectric layers 27A may be cut through the first linear opening 20. Subsequently, the first spacer layer 26A may be selectively recessed. The remaining first spacer layers may become the first spacers 26, and the second inter-cell dielectric layers may remain as indicated by reference numeral "27".

As the first spacers 26 are formed, linear surrounding recesses 28 surrounding the narrow sheets 13N may be formed on the nano sheet dielectric layer 25. Each of the second inter-cell dielectric layers 27 may be disposed between the linear surrounding recesses 28 that are vertically disposed. Dummy recesses 28U and 28L may be formed at higher and lower levels than the linear surrounding recesses 28.

Each of the first spacers 26 may surround the narrow sheets 13N at the same horizontal level in the third direction D3.

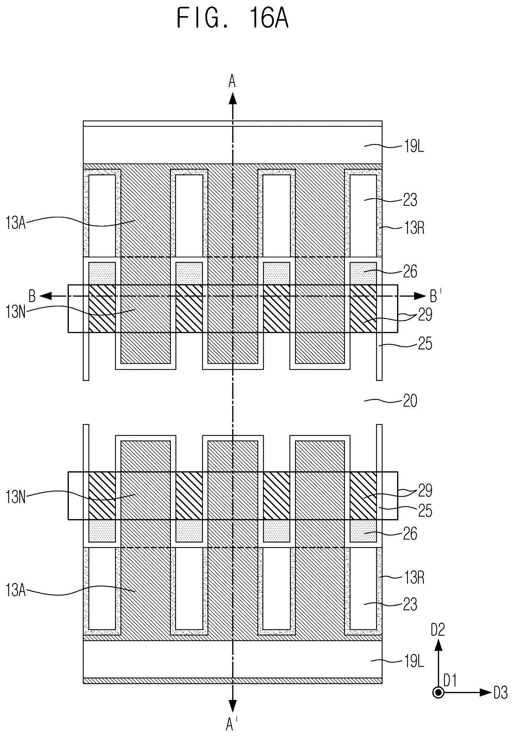

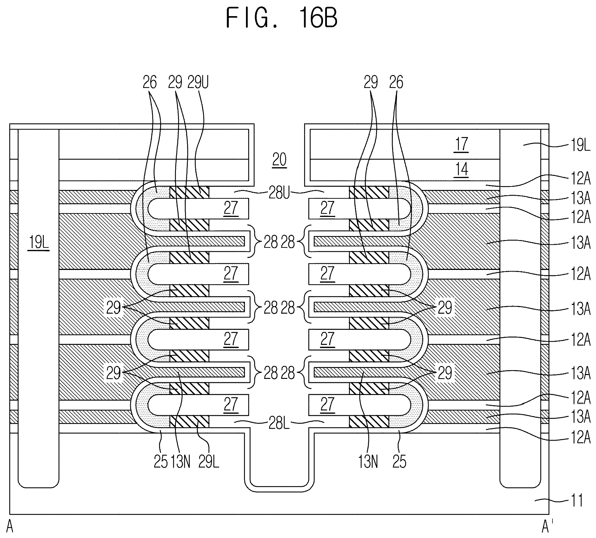

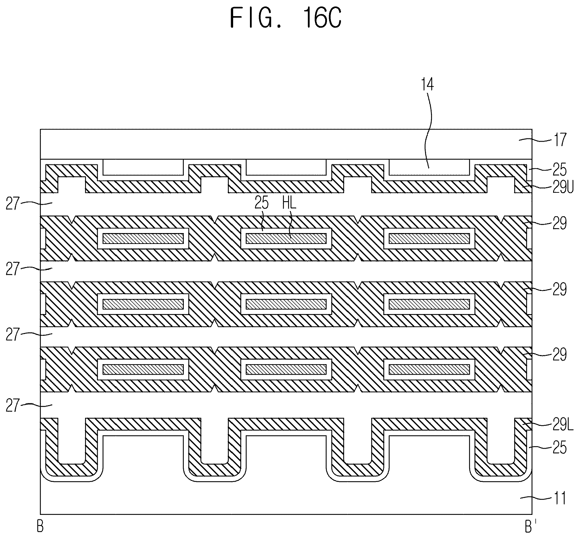

FIG. 16A is a plan view illustrating the structure at the narrow sheet level to describe a method for forming horizontal conductive lines 29. FIG. 16B is a cross-sectional view of the structure taken along line A-A' illustrated in FIG. 16A. FIG. 16C is a cross-sectional view of the structure taken along line B-B' illustrated in FIG. 16A.

Referring to FIGS. 16A to 16C, the horizontal conductive lines 29 may be formed to fill the linear surrounding recesses 28. The horizontal conductive lines 29 may horizontally extend in the third direction D3.

Forming the horizontal conductive lines 29 may include depositing a conductive material filling the linear surrounding recesses 28 on the nano sheet dielectric layer 25 and performing a horizontal etch-back process on the conductive material. Each of the horizontal conductive lines 29 may simultaneously surround the narrow sheets 13N at the same level. The horizontal conductive lines 29 may each include a metal-based material, a semiconductive material, or a combination thereof. The horizontal conductive lines 29 may each include molybdenum, molybdenum nitride, ruthenium, titanium nitride, tungsten, polysilicon, or a combination thereof. For example, the horizontal conductive lines 29 may each include a titanium nitride and tungsten (TiN/W) stack in which titanium nitride and tungsten are sequentially stacked. The horizontal conductive lines 29 may each include an N-type work function material or a P-type work function material. The N-type work function material may have a low work function of approximately 4.5 eV or less, and the P-type work function material may have a high work function of approximately 4.5 eV or greater. Each of the second inter-cell dielectric layers 27 may be disposed between a plurality of horizontal conductive lines 29 in the first direction D1. The horizontal conductive lines 29 that surround the narrow sheets 13N may be referred to as "gate-all-around (GAA) electrodes". The narrow sheets 13N may be referred to as "nano sheet channels", "nano wires" or "nano wire channels".

A lower-level dummy horizontal electrode 29L may be formed on the surface of the substrate 11. An upper-level dummy horizontal electrode 29U may be formed over an uppermost horizontal conductive line 29. The dummy horizontal electrodes 29L and 29U may each have a non-surrounding shape.

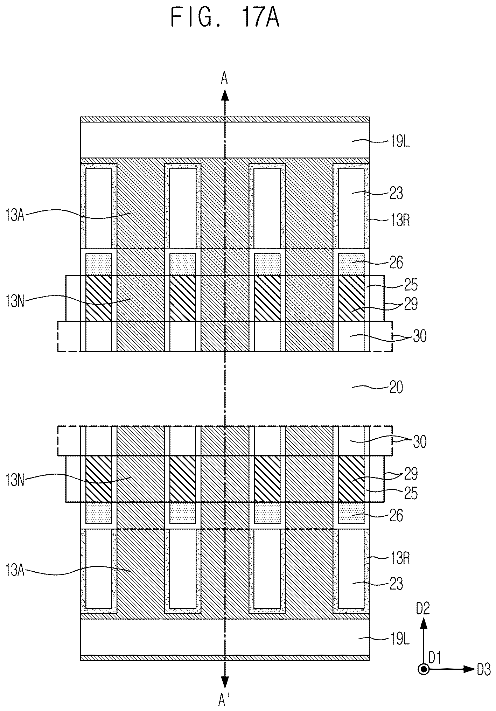

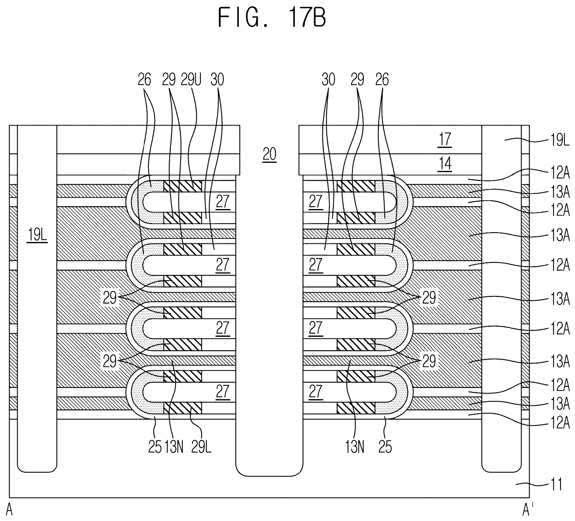

FIG. 17A is a plan view illustrating the structure at the narrow sheet level to describe a method for forming second spacers 30. FIG. 17B is a cross-sectional view of the structure taken along line A-A' illustrated in FIG. 17A.

Referring to FIGS. 17A and 17B, each of the second spacers 30 may be formed on one side of each of the horizontal conductive lines 29. The second spacer 30 may include silicon oxide, silicon nitride, silicon carbon oxide, an embedded air gap, or a combination thereof. Deposition and etch-back processes of a spacer material may be performed to form the second spacer 30. The second spacer 30 may include a stack of a silicon oxide liner and a silicon nitride liner.

After the second spacers 30 are formed, a portion of the nano sheet dielectric layer 25 may be cut to expose one side of each of the narrow sheets 13N.

Each of the second spacers 30 may be disposed on one side of each of the horizontal conductive lines 29 and surround the narrow sheets 13N at the same horizontal level in the third direction D3.

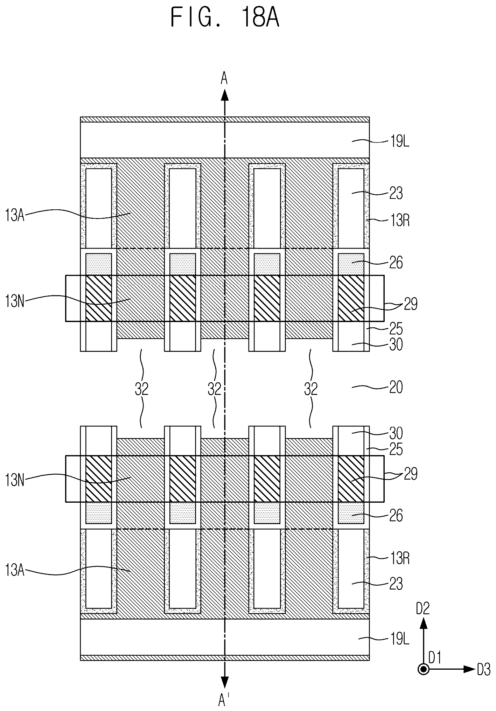

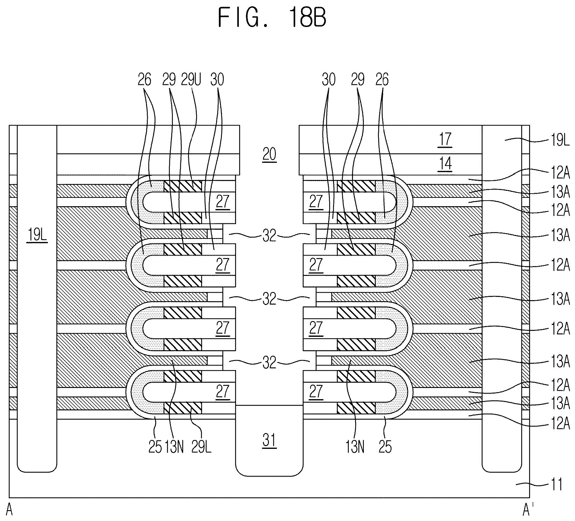

FIG. 18A is a plan view illustrating the structure at the narrow sheet level to describe a method for forming narrow sheet cuts 32. FIG. 18B is a cross-sectional view of the structure taken along line A-A' illustrated in FIG. 18A.

Referring to FIGS. 18A and 18B, a first bottom protection layer 31 may be formed on the surface of the substrate 11. The first bottom protection layer 31 may include a material having an etch selectivity with respect to the substrate 11. The first bottom protection layer 31 may include a dielectric material. The first bottom protection layer 31 may include silicon oxide, silicon nitride, silicon carbon oxide, or a combination thereof.

Subsequently, one side of the narrow sheets 13N and one side of the nano sheet dielectric layers 25 may be cut. Accordingly, the narrow sheet cuts 32 that are horizontally sunken from edges of the second spacers 30 may be formed. While the narrow sheet cuts 32 are formed, the surface of the substrate 11 may be protected by the first bottom protection layer 31.

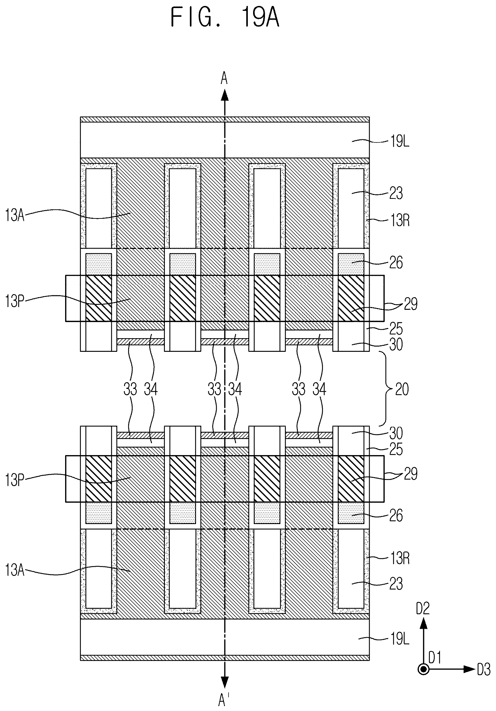

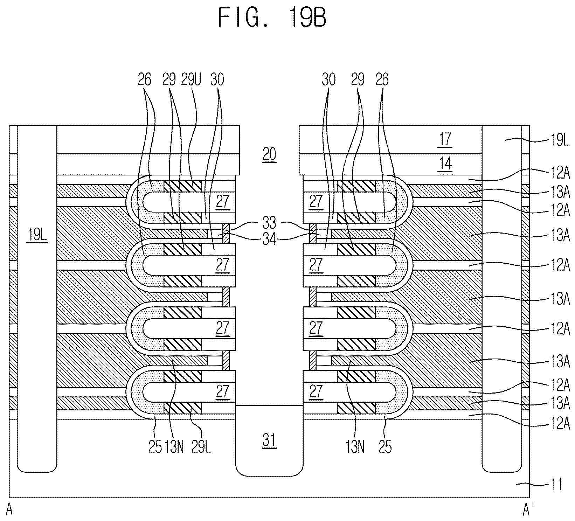

FIG. 19A is a plan view illustrating the structure at the narrow sheet level to describe a method for forming first contact nodes 33. FIG. 19B is a cross-sectional view of the structure taken along line A-A' illustrated in FIG. 19A.

Referring to FIGS. 19A and 19B, the first contact nodes 33 may be selectively formed from edges of the narrow sheets 13N. The first contact nodes 33 may be formed through selective epitaxial growth (SEG). The first contact nodes 33 may be epitaxial layers of a silicon layer. The first contact nodes 33 may be doped silicon epitaxial layers.

First doped regions 34 may be formed within one side of the narrow sheets 13N. A heat treatment process may be performed to form the first doped regions 34, and thus dopants may be diffused from the first contact nodes 33.

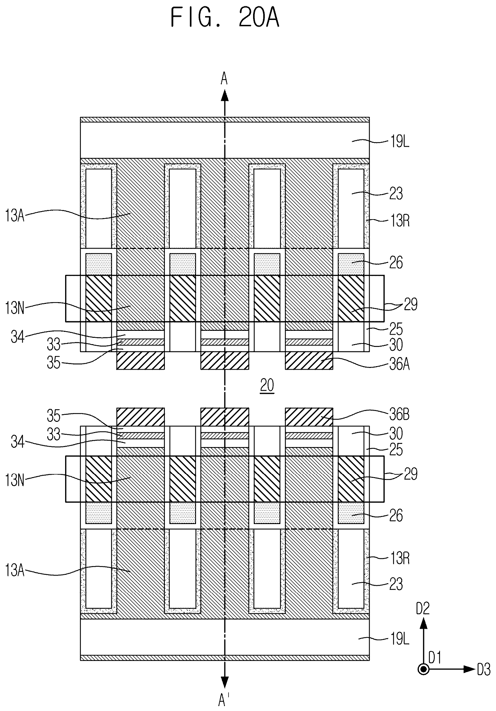

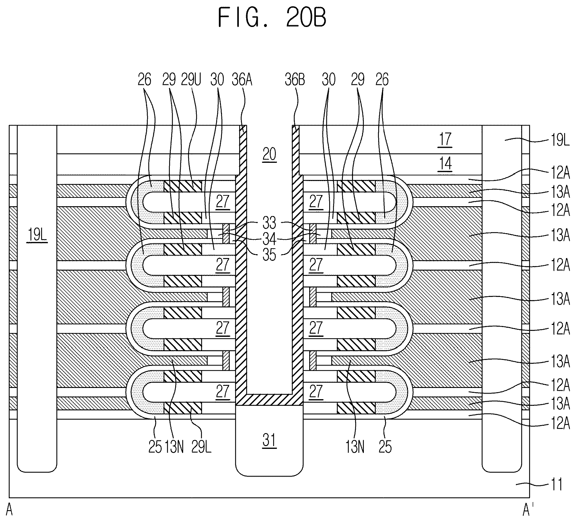

FIG. 20A is a plan view illustrating the structure at the narrow sheet level to describe a method for forming vertical conductive lines 36A and 36B. FIG. 20B is a cross-sectional view of the structure taken along line A-A' illustrated in FIG. 20A.

Referring to FIGS. 20A and 20B, the vertical conductive lines 36A and 36B may be formed on the first contact nodes 33. Before the vertical conductive lines 36A and 36B are formed, ohmic contact layers 35 may be formed on the first contact nodes 33. The ohmic contact layers 35 may each include metal silicide such as titanium silicide or molybdenum silicide.

Forming the vertical conductive lines 36A and 36B may include depositing a metal material and etching the metal material. Bottom portions of the vertical conductive lines 36A and 36B adjacent to each other may be coupled to each other.

The vertical conductive lines 36A and 36B may be vertically oriented in the first direction D1. The vertical conductive lines 36A and 36B may each include a bit line. The vertical conductive lines 36A and 36B may each include metal, a metal-based material, or a combination thereof. The vertical conductive lines 36A and 36B may each include metal, metal nitride, metal silicide, or a combination thereof. The vertical conductive lines 36A and 36B may each include titanium nitride, tungsten, or a combination thereof. For example, the vertical conductive lines 36A and 36B may include a titanium nitride/tungsten (TiN/W) stack in which titanium nitride and tungsten are sequentially stacked. The bottom portions of the vertical conductive lines 36A and 36B may be merged with each other.

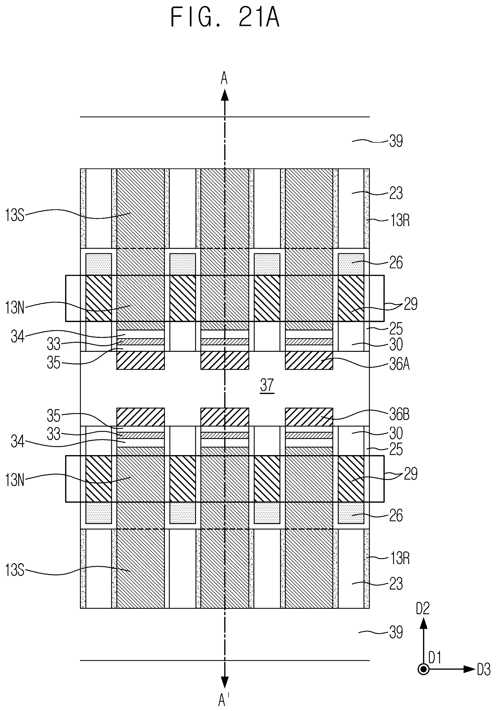

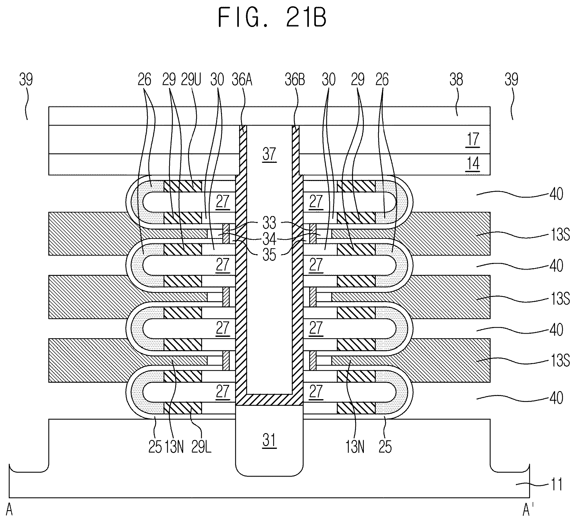

FIG. 21A is a plan view illustrating the structure at a nano sheet level to describe a method for forming second linear openings 39. FIG. 21B is a cross-sectional view of the structure taken along line A-A' illustrated in FIG. 21A.

Referring to FIGS. 21A and 21B, an array isolation layer 37 may be formed between the vertical conductive lines 36A and 36B. The array isolation layer 37 may include a dielectric material. The array isolation layer 37 may fill a space between the vertical conductive lines 36A and 36B. The array isolation layer 37 may include silicon oxide.

Forming the array isolation layer 37 may include depositing a dielectric material and planarizing the dielectric material.

Subsequently, the second linear sacrificial layer 19L may be selectively removed using a third hard mask layer 38. Accordingly, the second linear openings 39 may be formed.

After the second linear openings 39 are formed, the first mold layers 12A may be selectively recessed through the second linear openings 39. To selectively recess the first mold layers 12A, a difference in etch selectivity between the first mold layers 12A and the original body portions 13A may be used. The first mold layers 12A may be removed using a wet etch process or a dry etch process. For example, when the first mold layers 12A include silicon germanium layers and the original body portions 13A include monocrystalline silicon layers, the silicon germanium layers may be etched using an etchant or etch gas having a selectivity with respect to the monocrystalline silicon layers.

Subsequently, the original body portions 13A may be recessed. To recess the original body portions 13A, the wet etch process or the dry etch process may be used. Vertical thicknesses of the original body portions 13A may be reduced, as indicated by reference numeral "13S". Hereinafter, the original body portions having the reduced vertical thicknesses are referred to as "recessed body portions 13S".

Each of inter-body recesses 40 may be formed between the recessed body portions 13S that are vertically disposed.

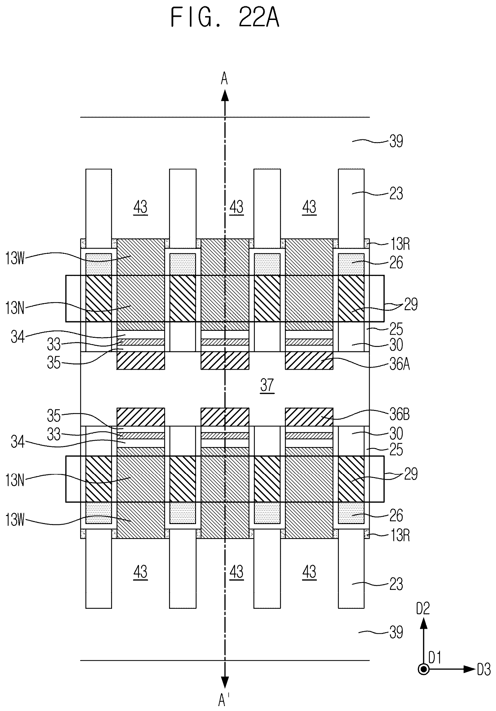

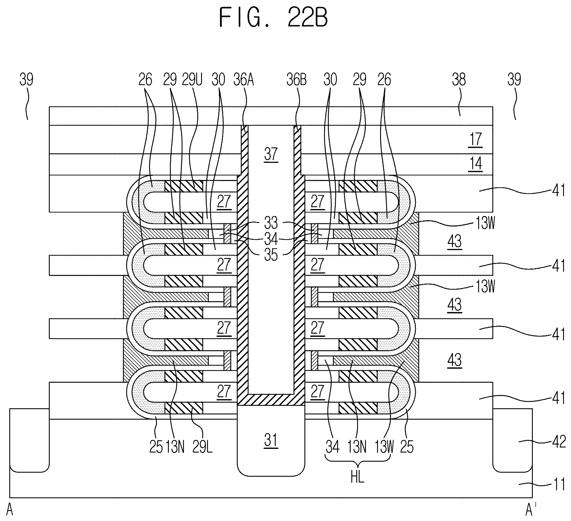

FIG. 22A is a plan view illustrating the structure at the nano sheet level to describe a method for forming nano sheets HL. FIG. 22B is a cross-sectional view of the structure taken along line A-A' illustrated in FIG. 22A.

Referring to FIGS. 22A and 22B, third inter-cell dielectric layers 41 may be formed to fill the inter-body recesses 40. The third inter-cell dielectric layers 41 may each include silicon oxide.

After the third inter-cell dielectric layers 41 are formed, second bottom protection layers 42 may be formed on bottom portions of the second linear openings 39. The second bottom protection layers 42 may each include a material having an etch selectivity with respect to the substrate 11. The second bottom protection layers 42 may each include a dielectric material. The second bottom protection layers 42 may each include silicon oxide, silicon nitride, silicon carbon oxide, or a combination thereof.

After the second bottom protection layers 42 are formed, storage openings 43 may be formed by horizontal recessing of the recessed body portions 13S. The storage openings 43 may be referred to as "capacitor openings". The nano sheets HL may be formed by the horizontal recessing of the recessed body portions 13S. Each of the nano sheets HL may include the first doped region 34, the narrow sheet 13N and a wide sheet 13W. The wide sheet 13W of the nano sheet HL may refer to the recessed body portion 13S remaining after the recessing. An average vertical height of the wide sheets 13W of the nano sheets HL in the first direction D1 may be greater than an average vertical height of the narrow sheets 13N. A thickness of the wide sheet 13W of the nano sheet HL may gradually increase in the second direction D2. A horizontal length of the wide sheet 13W in the second direction D2 may be less than a horizontal length of the narrow sheet 13N. The wide sheet 13W of the nano sheet HL may have a fan-like shape. The wide sheet 13W may be referred to as a "fan-shaped sheet", and the narrow sheet 13N may be referred to as a "flat plate-shaped sheet".

To form the nano sheets HL each including the wide sheet 13W, the recessed body portions 13S may be isotropically or anisotropically etched. One side of the wide sheet 13W, i.e., the side exposed by each of the storage openings 43, may have a flat shape. The one side of the wide sheet 13W may have various shapes.

The one side of the wide sheet 13W may have various shapes. For example, the one side of the wide sheet 13W may have a rounded concave shape, a rounded convex shape, an angled concave shape, or an angled convex shape.

The second bottom protection layers 42 and a lowermost third inter-cell dielectric layer 41 may prevent loss of the substrate 11 during the recessing process of the recessed body portions 13S.

Each of the storage openings 43 may be disposed between the third inter-cell dielectric layers 41 in the first direction D1.

In some embodiments, the horizontal recessing of the recessed body portions 13S for forming the wide sheets 13W may stop at a boundary area between the narrow sheet 13N and the wide sheet 13W.

The first spacer 26 may surround the wide sheets 13W at the same horizontal level, which are disposed in third direction D3. The second spacer 30 may surround the narrow sheets 13N at the same horizontal level, which are disposed in the third direction D3.

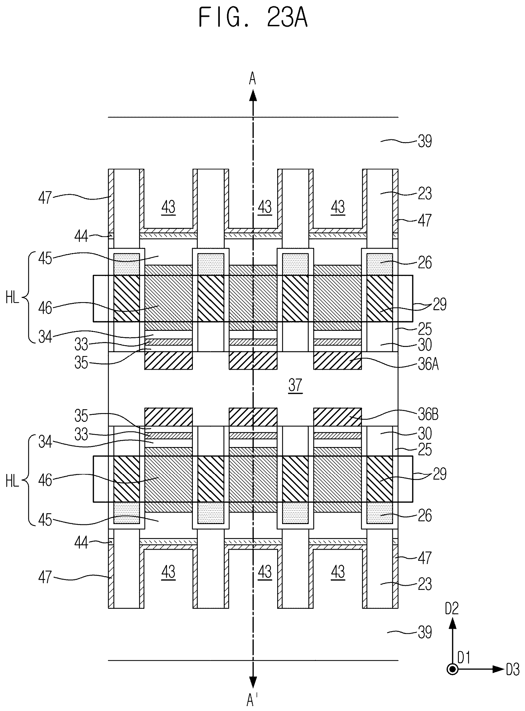

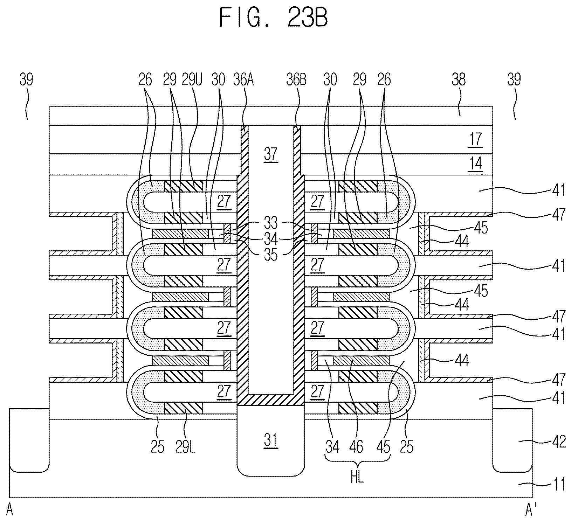

FIG. 23A is a plan view illustrating the structure at the nano sheet level to describe a method for forming first electrodes 47. FIG. 23B is a cross-sectional view illustrating the structure taken along line A-A' illustrated in FIG. 23A.

Referring to FIGS. 23A and 23B, a pre-cleaning process may be performed on the surfaces of the wide sheets 13W.

Second contact nodes 44 may be formed on the wide sheets 13W. Forming the second contact nodes 44 may include selective epitaxial growth (SEG). For example, a semiconductive material may be grown from the side surfaces of the wide sheets 13W through the SEG. The second contact nodes 44 may each include SEG Si. Because the wide sheets 13W each include monocrystalline silicon, a silicon layer may be epitaxially grown along crystal surfaces of the side surfaces of the wide sheets 13W.

The second contact nodes 44 may each include a dopant. When the silicon layer is grown using the SEG, dopants may be doped in situ. Accordingly, the second contact nodes 44 may each be a doped epitaxial layer. The second contact nodes 44 may each include an N-type dopant as the dopant. The N-type dopant may include phosphorus, arsenic, antimony, or a combination thereof. The second contact nodes 44 may each include a phosphorus-doped silicon epitaxial layer formed by the SEG, i.e., a doped SEG SiP. In some embodiments, the second contact nodes 44 may be formed through deposition and etch-back processes of doped polysilicon.

Each of the second contact nodes 44 may be disposed between the third inter-cell dielectric layers 41 that are vertically stacked. The second contact nodes 44 may correspond to the second contact node SNC illustrated in FIG. 4B.

Second doped regions 45 may be formed in the wide sheets 13W. A heat treatment process may be performed to form the second doped regions 45, and thus dopants may be diffused from the second contact nodes 44.

A channel 46 may be defined between the first doped region 34 and the second doped region 45. A horizontal arrangement of the first doped region 34, the channel 46 and the second doped region 45 may form each of the nano sheets HL.

Each of the nano sheets HL may include the first doped region 34, the second doped region 45, and the channel 46. The first doped region 34 and the channel 46 may be formed in the narrow sheet 13N. The second doped region 45 may be formed in the wide sheet 13W. A portion of each of the second doped regions 45 may extend into the narrow sheets 13N. One side of each of the second doped regions 45 of the nano sheets HL may be coupled to the channel 46. The other side of each of the second doped regions 45 of the nano sheets HL may be coupled to the second contact nodes 44.

The first spacer 26 may surround the second doped regions 45 at the same horizontal level, which are disposed in the third direction D3. The second spacer 30 may surround the first doped regions 34 at the same horizontal level, which are disposed in the third direction D3. The horizontal conductive line 29 may surround the channels 46 at the same horizontal level, which are disposed in the third direction D3.

In some embodiments, an ohmic contact layer including metal silicide may be further formed after the second contact nodes 44 are formed.

As described above, the nano sheets HL may be formed by subsequent selective recessing processes performed on the second mold layers 13 of the mold stack SB, and each of the nano sheets HL may include the narrow sheet 13N and the wide sheet 13W. The first doped regions 34 and the channels 46 may be formed in the narrow sheets 13N, and the second doped regions 45 may be formed in the wide sheets 13W.

Subsequently, the first electrodes 47 of a data storage element may be formed on the second contact nodes 44. The first electrodes 47 may each have a horizontally-oriented cylindrical shape. Each of the first electrodes 47 may be disposed in a different one of the storage openings 43. The first electrodes 47 adjacent to each other in the second direction D2 may be spaced apart from each other by the second linear openings 39. The first electrodes 47 adjacent to each other in the first direction D1 may be spaced apart from each other by the third inter-cell dielectric layers 41. Forming the first electrodes 47 may include depositing a metal material, gap-filling a sacrificial material, and isolating the metal material in a vertical/horizontal direction. The sacrificial material may include oxide or polysilicon.

Each of the first electrodes 47 may include an inner space and a plurality of outer surfaces. The inner space of the first electrode 47 may include a plurality of inner surfaces. The outer surfaces of the first electrode 47 may include a vertical outer surface and a plurality of horizontal outer surfaces. The vertical outer surface of the first electrode 47 may vertically extend in the first direction D1. The horizontal outer surfaces of the first electrode 47 may horizontally extend in the second direction D2 or the third direction D3. The inner space of the first electrode 47 may be a three-dimensional space. The first electrode 47 may have a cylindrical shape.

Among the outer surfaces of the first electrode 47, the vertical outer surface may be electrically coupled to the nano sheet HL and the second contact node 44.

The first electrode 47 may include metal, noble metal, metal nitride, conductive metal oxide, conductive noble metal oxide, metal carbide, metal silicide, or a combination thereof. For example, the first electrode 47 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof.

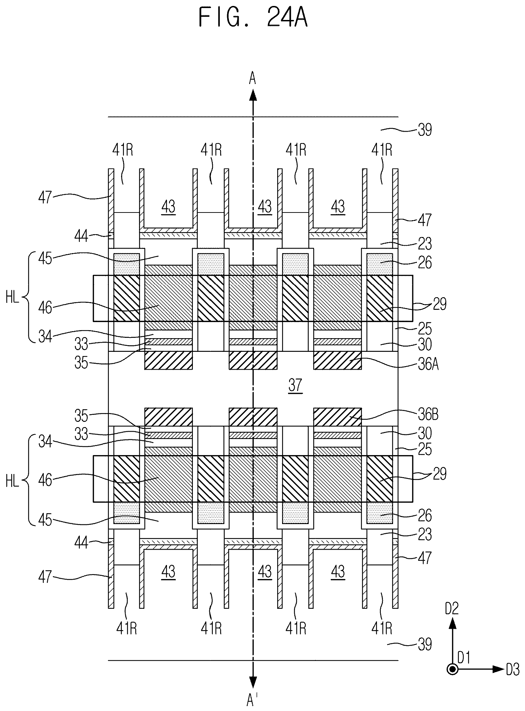

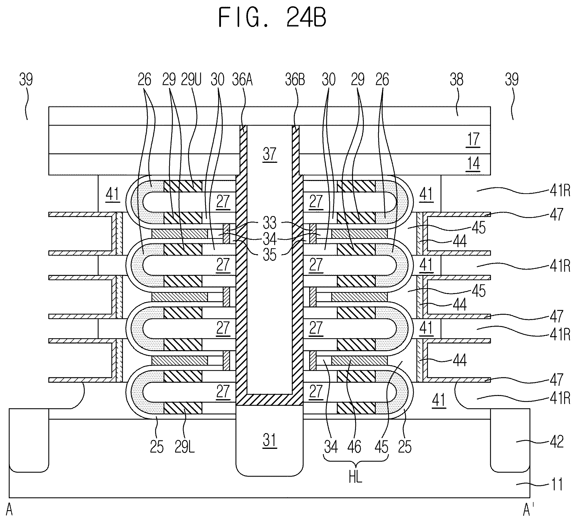

FIG. 24A is a plan view illustrating the structure at the nano sheet level to describe a method for partially recessing the first and third inter-cell dielectric layers 23 and 41. FIG. 24B is a cross-sectional view of the structure taken along line A-A' illustrated in FIG. 24A.

Referring to FIGS. 24A and 24B, portions of the first and third inter-cell dielectric layers 23 and 41 may be horizontally recessed (refer to reference numeral "41R"). Accordingly, outer walls of the first electrodes 47 may be partially exposed. The first electrodes 47 may each have a semi-cylindrical shape. Horizontal recess depths of the third inter-cell dielectric layers 41 may be depths that do not expose the second contact nodes 44. The semi-cylindrical shape of each of the first electrodes 47 may include cylindrical inner surfaces and semi-cylindrical outer surfaces. The semi-cylindrical outer surfaces of the first electrode 47 may be exposed in the first direction D1 and the third direction D3.

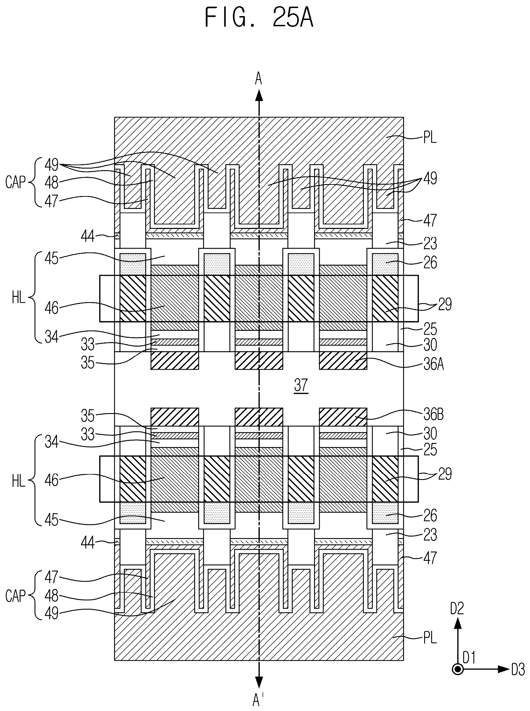

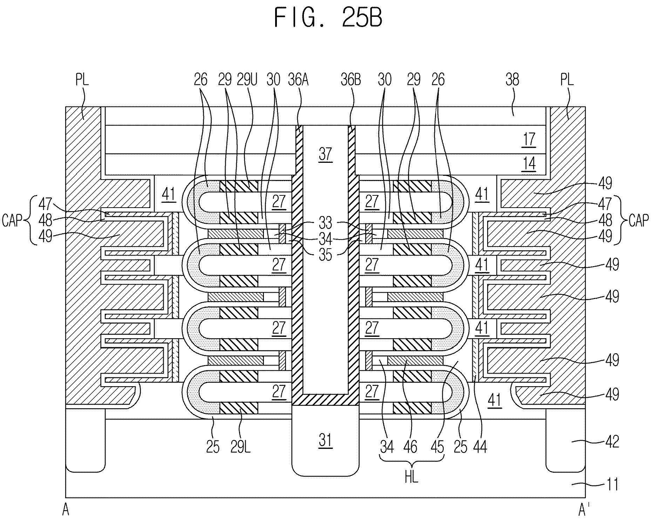

FIG. 25A is a plan view illustrating the structure at the nano sheet level to describe a method for forming a second electrode 49. FIG. 25B is a cross-sectional view of the structure taken along line A-A' illustrated in FIG. 25A.

Referring to FIGS. 25A and 25B, a dielectric layer 48 and the second electrode 49 may be sequentially formed on the first electrodes 47. The first electrode 47, the dielectric layer 48 and the second electrode 49 may be formed as a data storage element CAP. The second electrodes 49 of the data storage elements CAP may be merged with one another and form a common plate PL.

The dielectric layer 48 and the second electrode 49 may be disposed on the cylindrical inner surfaces of the first electrode 47. A portion of the dielectric layer 48 and a portion of the second electrode 49 may extend to be disposed on the semi-cylindrical outer surfaces of the first electrode 47. The second electrode 49 may vertically extend in the first direction D1.

The dielectric layer 48 may be referred to as a "capacitor dielectric layer" or a "memory layer". The dielectric layer 48 may include silicon oxide, silicon nitride, a high-k material, a ferroelectric material, an antiferroelectric material, a perovskite material, or a combination thereof. The dielectric layer 48 may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). The dielectric layer 48 may include a ZA (ZrO₂/Al₂O₃) stack, a ZAZ (ZrO₂/Al₂O₃/ZrO₂) stack, a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, a HZHZ (HfO₂/ZrO₂/HfO₂/ZrO₂) stack, an AHZAZHA (Al₂O₃/HfO₂/ZrO₂/Al₂O₃/ZrO₂/HfO₂/Al₂O₃) stack, or a ZHZAZHZAT (ZrO₂/HfO₂/ZrO₂/Al₂O₃/ZrO₂/HfO₂/ZrO₂/Al₂O₃/TiO₂) stack.

The second electrode 49 may include metal, noble metal, metal nitride, conductive metal oxide, conductive noble metal oxide, metal carbide, metal silicide, or a combination thereof. For example, the second electrode 49 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, a titanium silicon nitride/titanium nitride/tungsten (TiSiN/TiN/W) stack, or a combination thereof. The second electrode 49 may also include a combination of a metal-based material and a silicon-based material. For example, a titanium nitride, tungsten and polysilicon may be sequentially stacked in the second electrode 49.

In some embodiments, a plurality of interface control layers may be further included between the first electrode 47 and the dielectric layer 48 and between the second electrode 49 and the dielectric layer 48 to alleviate leakage current. Each of the interface control layers may include titanium oxide (TiO₂), tantalum oxide (Ta₂O₅), niobium oxide (Nb₂O₅), niobium nitride (NbN), niobium oxynitride (NbON), or a combination thereof. The data storage element CAP may include a first interface control layer, a second interface control layer, or a combination thereof. The first interface control layer and the second interface control layer may be conductive or dielectric. The first interface control layer may be formed between the first electrode 47 and the dielectric layer 48. The second interface control layer may be formed between the dielectric layer 48 and the second electrode 49. The first interface control layer and the second interface control layer may be of the same material or different materials. For example, a structure in which the first interface control layer, dielectric layer 48 and second interface control layer of the data storage element CAP are sequentially stacked may include an NZHZAZHZATN (Nb₂O₅/ZrO₂/HfO₂/ZrO₂/Al₂O₃/ZrO₂/HfO₂/ZrO₂/Al₂O₃/TiO₂/Nb₂O₅) stack.

In some embodiments, the recessing of the first and third inter-cell dielectric layers 23 and 41 illustrated in FIG. 24B may be omitted. Thereafter, as illustrated in FIG. 25B, the dielectric layer 48 and the second electrode 49 may be formed. Accordingly, the data storage element CAP including the first electrode 49 having a concave shape may be formed.

In an embodiment, an occupied area of the channel 46 may increase by the sheet expansion tab 13T as shown in FIG. 10A. In addition, because the sheet expansion tab 13T is formed, poor connection between the horizontal conductive lines 29 may be prevented even though a gap between the nano sheets HL increases due to a cleaning process other than an etch process.

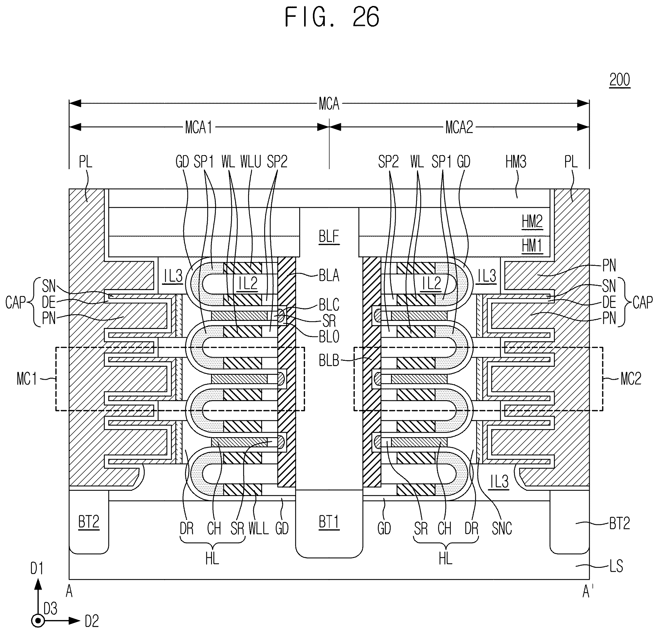

FIG. 26 is a schematic cross-sectional view of a semiconductor device 200 in accordance with an embodiment of the present disclosure. The semiconductor device 200 illustrated in FIG. 26 may be similar to the semiconductor device 100 illustrated in FIGS. 3 to 4C. FIG. 26 illustrates the semiconductor device 200 in accordance with another embodiment of the semiconductor device 100 taken along line A-A' illustrated in FIG. 4A.

Referring to FIG. 26, the semiconductor device 200 may include a memory cell array MCA disposed over a lower structure LS. The memory cell array MCA may include a first sub-cell array MCA1 and a second sub-cell array MCA2. The first sub-cell array MCA1 may include a three-dimensional array of first memory cells MC1. The second sub-cell array MCA2 may include a three-dimensional array of second memory cells MC2. The first sub-cell array MCA1 may include vertical and horizontal arrangements of the first memory cells MC1. The second sub-cell array MCA2 may include vertical and horizontal arrangements of the second memory cells MC2.

Each of the first memory cells MC1 may include a first vertical conductive line BLA, a data storage element CAP, a nano sheet HL between the first vertical conductive line BLA and the data storage element CAP, a second conductive line WL surrounding the nano sheet HL, and a nano sheet dielectric layer GD between the nano sheet HL and the second conductive line WL. Each of the second memory cells MC2 may include a second vertical conductive line BLB, a data storage element CAP, a nano sheet HL between the second vertical conductive line BLB and the data storage element CAP, a second conductive line WL surrounding the nano sheet HL, and a nano sheet dielectric layer GD between the nano sheet HL and the second conductive line WL. The nano sheet dielectric layer GD may include a deposition portion GD1 and an oxidation portion GD2 as described with reference to FIG. 4C. The data storage elements CAP may each include a first electrode SN, a dielectric layer DE, and a second electrode PN. The second electrodes PN of the data storage elements CAP may be merged with each other and form a common plate PL. The nano sheets HL may each include a first doped region SR, a channel CH, and a second doped region DR.

Each of the first and second memory cells MC1 and MC2 may further include a first spacer SP1, a second spacer SP2, a first contact node BLC, a second contact node SNC, and an ohmic contact layer BLO. The first contact node BLC may be disposed between the first and second vertical conductive lines BLA and BLB and the nano sheet HL. The second contact node SNC may be disposed between the nano sheet HL and the first electrode SN.

Referring to FIG. 4A and FIG. 26, each of first inter-cell dielectric layers IL1 may be disposed between the data storage elements CAP adjacent to each other in a third direction D3. Each of second inter-cell dielectric layers IL2 may be disposed between the second conductive lines WL vertically stacked in a first direction D1. Each of third inter-cell dielectric layers IL3 may be disposed between the first electrodes SN of the data storage elements CAP vertically stacked in the first direction D1.

The memory cell array MCA may include a dummy second conductive line WLU disposed at a level higher than an uppermost second conductive line WL and a dummy second conductive line WLL disposed at a level lower than a lowermost second conductive line WL. The dummy second conductive lines WLU and WLL may each have a linear shape extending horizontally.

The memory cell array MCA may include a stack of a plurality of hard mask layers HM1, HM2 and HM3 disposed at a level higher than the uppermost second conductive line WL.

The memory cell array MCA may include a plurality of first and second bottom protection layers BT1 and BT2. The first bottom protection layers BT1 may prevent the first conductive lines BL and the lower structure LS from coming into electrical contact with each other. The second bottom protection layer BT2 may prevent the data storage element CAP and the lower structure LS from coming into electrical contact with each other.

The first memory cells MC1 of the first sub-cell array MCA1 may share the first vertical conductive line BLA. The second memory cells MC2 of the second sub-cell array MCA2 may share the second vertical conductive line BLB. The first vertical conductive line BLA and the second vertical conductive line BLB may be electrically isolated from each other. An array isolation layer BLF may be disposed between the first vertical conductive line BLA and the second vertical conductive line BLB. Bottom portions of the first and second vertical conductive lines BLA and BLB may be isolated from each other by the first bottom protection layer BT1.

The first contact nodes BLC of the first and second sub-cell arrays MCA1 and MCA2 may be selectively grown from the nano sheets HL. The first contact nodes BLC may be formed by selective epitaxial growth (SEG). For example, the first contact nodes BLC may be silicon epitaxial layers formed by the SEG. The first contact nodes BLC may be doped silicon epitaxial layers. The first doped regions SR may include impurities diffused from the first contact nodes BLC.

As described above, in the semiconductor device 200, the first vertical conductive line BLA of the first sub-cell array MCA1 may be electrically isolated from the second vertical conductive line BLB of the second sub-cell array MCA2.

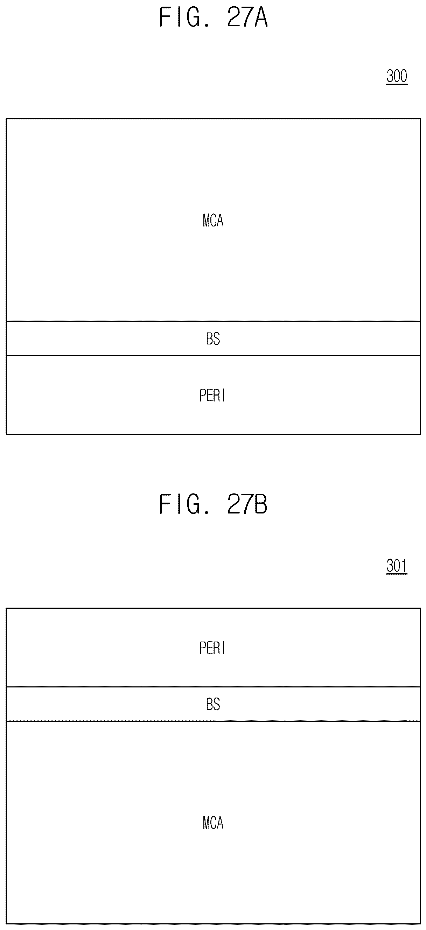

FIGS. 27A and 27B are schematic cross-sectional views of semiconductor devices 300 and 301 in accordance with embodiments of the present disclosure.

Referring to FIG. 27A, the semiconductor device 300 may include a memory cell array MCA, a peripheral circuit portion PERI, and a bonding interface BS. The bonding interface BS may be disposed between the memory cell array MCA and the peripheral circuit portion PERI. In the semiconductor device 300, the memory cell array MCA may be disposed at a level higher than the peripheral circuit portion PERI. The semiconductor device 300 may be referred to as a "Peri Under Cell array (PUC) structure". The memory cell array MCA may include a substrate on which back-grinding is performed and an array of memory cells. For example, as described with reference to FIG. 25B, after the data storage element CAP is formed, the substrate 11 may be flipped over through wafer-flipping, and then a back side of the substrate 11 may be partially ground.

Referring to FIG. 27B, the semiconductor device 301 may include a memory cell array MCA, a peripheral circuit portion PERI, and a bonding interface BS. The bonding interface BS may be disposed between the memory cell array MCA and the peripheral circuit portion PERI. In the semiconductor device 301, the memory cell array MCA may be disposed at a level lower than the peripheral circuit portion PERI. The semiconductor device 301 may be referred to as a "Cell array Under Peri (CUP) structure". Forming the peripheral circuit portion PERI may include forming a plurality of control circuits on a peripheral circuit substrate and forming multi-level interconnection on the control circuits.

In FIG. 27A and FIG. 27B, the bonding interface BS may include pad bonding, hybrid bonding, oxide-to-oxide bonding, metal-to-metal bonding, or a combination thereof. The hybrid bonding may refer to a combination of the pad bonding and the oxide-to-oxide bonding. The pad bonding may include forming a cell bonding pad for the memory cell array MCA, forming a peripheral circuit bonding pad for the peripheral circuit portion PERI, performing wafer-flipping to dispose the cell bonding pad and the peripheral circuit bonding pad face to face with each other, and performing wafer bonding.

The semiconductor device 300 illustrated in FIG. 27A may perform the wafer-flipping on the substrate on which the memory cell array is formed so that the cell bonding pad and the peripheral circuit bonding pad face each other, after the cell bonding pad and the peripheral circuit bonding pad are formed. The semiconductor device 301 illustrated in FIG. 27B may perform the wafer-flipping on the substrate on which the peripheral circuit portion is formed so that the cell bonding pad and the peripheral circuit bonding pad face each other, after the cell bonding pad and the peripheral circuit bonding pad are formed.

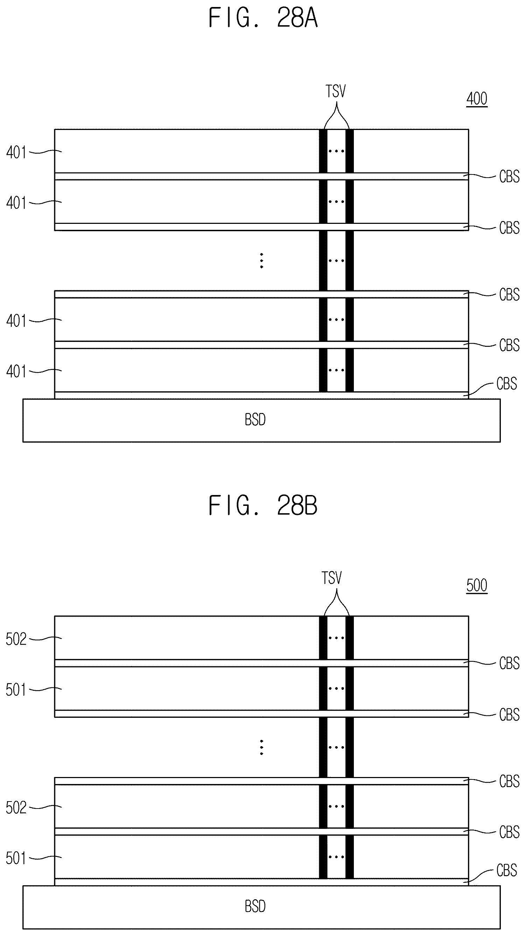

FIGS. 28A and 28B illustrate various views illustrating stack assemblies 400 and 500 in accordance with embodiments of the present disclosure.

Referring to FIG. 28A, the stack assembly 400 may include an assembly of semiconductor dies. For example, the stack assembly 400 may include a first semiconductor die BSD and a plurality of second semiconductor dies 401 which are stacked over the first semiconductor die BSD. The first semiconductor die BSD may include logic circuits. Each of the second semiconductor dies 401 may include memory cell arrays according to embodiments described above.

Each of the second semiconductor dies 401 may include structures in which a memory cell array and a peripheral circuit portion are stacked, for example, the semiconductor device 300 illustrated in FIG. 27A or the semiconductor device 301 illustrated in FIG. 27B. The logic circuits of the first semiconductor die BSD may be different from the peripheral circuit portions of the second semiconductor dies 401. The second semiconductor dies 401 may be at a chip level or a wafer level.

The second semiconductor dies 401 may be electrically coupled to each other through a plurality of through silicon vias TSV and bonding interfaces CBS. The first semiconductor die BSD and a lowermost second semiconductor die 401 may be electrically coupled to each other through the bonding interface CBS. The second semiconductor dies 401 may be referred to as "core dies", "semiconductor chips", or "memory chips".

The bonding interface CBS may include micro-bump, pad bonding, hybrid bonding, oxide-to-oxide bonding, metal-to-metal bonding, or a combination thereof.

Referring to FIG. 28B, the stack assembly 500 may include an assembly of semiconductor dies. For example, the stack assembly 500 may include a first semiconductor die BSD, and a stack over the first semiconductor die BSD. The stack may include a plurality of second semiconductor dies 501, and a plurality of third semiconductor dies 502, which are alternatively stacked. The first semiconductor die BSD may include logic circuits. Each of the second semiconductor dies 501 and each of the third semiconductor dies 502 may include memory cell arrays according to embodiments described above. The second semiconductor dies 501 and the third semiconductor dies 502 may have different structures.

Each of the second semiconductor dies 501 may include the semiconductor device 300 illustrated in FIG. 27A in which a memory cell array is stacked over a peripheral circuit portion. Each of the third semiconductor dies 502 may include the semiconductor device 301 illustrated in FIG. 27B in which a peripheral circuit portion is stacked over a memory cell array.

In some embodiments, each of the second semiconductor dies 501 may include the semiconductor device 301 illustrated in FIG. 27B in which a peripheral circuit portion is stacked over a memory cell array, and each of the third semiconductor dies 502 may include the semiconductor device 300 illustrated in FIG. 27A in which a memory cell array is stacked over a peripheral circuit portion.

The logic circuits of the first semiconductor die BSD may be different from the peripheral circuit portions of the second and third semiconductor dies 501 and 502. The second and third semiconductor dies 501 and 502 may be at a chip level or a wafer level.

The second and third semiconductor dies 501 and 502 may be electrically coupled to each other through a plurality of through silicon vias TSV and bonding interfaces CBS. The first semiconductor die BSD and a lowermost second semiconductor die 501 may be electrically coupled to each other through the bonding interface CBS. The second and third semiconductor dies 501 and 502 may be referred to as "core dies", "semiconductor chips", or "memory chips".

The bonding interface CBS may include micro-bump, pad bonding, hybrid bonding, oxide-to-oxide bonding, metal-to-metal bonding, or a combination thereof.

In some embodiments, wafer-flip and back grinding may be performed to form the bonding interface CBS. For example, the wafer-flipping and back-grinding may be performed on the second semiconductor dies 501 and/or the third semiconductor dies 502.

The stack assemblies 400 and 500 described with reference to FIGS. 28A and 28B may be high bandwidth memories.

According to various embodiments of the present disclosure, a nano sheet dielectric layer may be formed through deposition and oxidation processes, thereby providing the capability to improve a self-alignment margin of a word line having a gate-all-around shape of a 3D memory cell.

According to various embodiments of the present disclosure, an occupied area of a channel may increase, thereby improving the characteristics of a cell transistor that incorporates that channel, including, for example, enhancing the amount of current the transistor can conduct, threshold voltage, and output resistance.

According to various embodiments of the present disclosure, the reliability and performance of a 3D memory device may be significantly improved (for example, in comparison to 3D memory devices that do not incorporate the features of the present disclosure).

While the embodiments of the present disclosure has been illustrated and described with respect to specific embodiments and drawings, the disclosed embodiments are not intended to be restrictive. Further, it is noted that the embodiments may be achieved in various ways through substitution, change, and modification, as those skilled in the art will recognize in light of the present disclosure, without departing from the spirit and/or scope of the present disclosure and the following claims. Furthermore, the embodiments may be combined to form additional embodiments.

## Claims

1. A method for fabricating a semiconductor device, the method comprising:
forming a horizontal arrangement of nano sheet target patterns over a substrate, wherein the nano sheet target patterns include initial sheets that are horizontally oriented and sheet expansion tabs disposed on both sides of each of the initial sheets;
performing a surface treatment on the nano sheet target patterns to form a horizontal arrangement of narrow sheets and nano sheet dielectric layers, each of the nano sheet dielectric layers surrounding a different one of the narrow sheets; and
forming a horizontal conductive line on the nano sheet dielectric layers, the horizontal conductive line surrounding the narrow sheets.

2. The method of claim 1, wherein the sheet expansion tabs each include an epitaxial layer.

3. The method of claim 1, wherein the initial sheets and the sheet expansion tabs include a same material.

4. The method of claim 1, wherein the initial sheets and the sheet expansion tabs each include a silicon-containing material.

5. The method of claim 1,
wherein the performing the surface treatment on the nano sheet target patterns includes:
forming a deposition portion surrounding the nano sheet target patterns; and
oxidizing surfaces of the nano sheet target patterns to form an oxidation portion.

6. The method of claim 5, wherein the deposition portion and the oxidation portion each include silicon oxide.

7. The method of claim 5, wherein the deposition portion includes metal-based oxide, and the oxidation portion includes silicon oxide.

8. The method of claim 1, wherein the forming of the horizontal arrangement of the nano sheet target patterns includes:
forming, over the substrate, a mold stack including a vertical arrangement of mold layers;
forming sacrificial isolation openings in the mold stack;
forming liners on surfaces of the sacrificial isolation openings;
forming, on the liners, sacrificial isolation layers that fill the sacrificial isolation openings;
forming a linear opening in the mold stack;
trimming portions of the mold layers through the linear opening to form a horizontal arrangement of the initial sheets;
removing the sacrificial isolation layers through the linear opening; and
cutting the liners through the linear opening to form the sheet expansion tabs.

9. The method of claim 8, wherein the liners each include epi-like polysilicon.

10. A semiconductor device comprising:
a horizontal arrangement of nano sheets including first doped regions, second doped regions, and channels between the first doped regions and the second doped regions;
nano sheet dielectric layers including oxidation portions and deposition portions, each of the oxidation portions surrounding a different one of the channels of the nano sheets, each of the deposition portions surrounding a different one of the oxidation portions;
horizontal conductive lines horizontally oriented on the nano sheet dielectric layers while surrounding the channels of the nano sheets;
vertical conductive lines each coupled to a different one of the first doped regions of the nano sheets; and
data storage elements each coupled to a different one of the second doped regions of the nano sheets.

11. The semiconductor device of claim 10, wherein the deposition portions and the oxidation portions each include silicon oxide.

12. The semiconductor device of claim 10, wherein the deposition portions include metal-based oxide, and the oxidation portions include silicon oxide.

13. The semiconductor device of claim 10, further comprising:
first contact nodes formed between the first doped regions and the vertical conductive lines; and
second contact nodes formed between the second doped regions and the data storage elements.

14. The semiconductor device of claim 13, wherein the first and second contact nodes each include a selective epitaxial layer.

15. The semiconductor device of claim 10, further comprising:
a first spacer horizontally oriented on the nano sheet dielectric layers while surrounding the second doped regions of the nano sheets; and
a second spacer horizontally oriented on the nano sheet dielectric layers while surrounding the first doped regions of the nano sheets.
